# EUROPEAN PATENT APPLICATION

(11) **EP 1 936 699 A1**
(43) Date of publication of application: **25.06.2008**
(21) Application number: 06811276.2
(22) Date of filing: 05.10.2006
(51) Int. Cl.: H01L 31/04

(54) **SOLAR CELL, SOLAR CELL PROVIDED WITH INTERCONNECTOR, SOLAR CELL STRING AND SOLAR CELL MODULE**

(30) Priority: 14.10.2005 JP 2005300488; 16.12.2005 JP 2005363606; 19.12.2005 JP 2005364690
(71) Applicant: Sharp Kabushiki Kaisha, Osaka-shi, Osaka 545-8522 (JP)
(72) Inventor: NAKAMURA, Kyotaro, Nara 630-8131 (JP); TSUNEMI, Akiko, Nara 639-2101 (JP); KANEKO, Masahiro, 837-2 Gose-shi, Nara 639-2200 (JP); TAKEOKA, Sadaya, Sakurai-shi, Nara 633-0003 (JP); SAGA, Tatsuo, Shiki-gun, Nara 636-0217 (JP); TAKAKI, Akihide, tokyo 134-0084 (JP); MIYAZAWA, Akira, Nara 635-0832 (JP); HIOKI, Masaomi, Asuka-mura, Takaichi-gun, Nara 634-0144 (JP); OHBASAMI, Masahiro, Nara 639-0252 (JP)
(74) Representative: Müller - Hoffmann & Partner
(86) International application number: PCT/JP2006/319938
(87) International publication number: WO 2007/043428

(57) **Abstract**

A solar cell includes a semiconductor substrate having a first main surface. On the first main surface, a bus bar electrode (13a) and a plurality of linear finger electrodes (13b) extending from the bus bar electrode (13a) are provided. The bus bar electrode (13a) includes a first connecting portion (51) to be connected to an interconnector and a first non-connecting portion (42) without connected to the interconnector. The first connecting portion (51) and the first non-connecting portion (42) are alternately arranged. An interconnector-equipped solar cell, a solar cell string and a solar cell module use this solar cell.

## Description

### TECHNICAL FIELD

The present invention relates to a solar cell, an interconnector-equipped solar cell, a solar cell string, and a solar cell module.

### BACKGROUND ART

For solar cells converting solar energy into electrical energy, recently expectations have been remarkably growing for their availability as a next-generation energy source, particularly in terms of global environmental issues. Solar cells are classified into various kinds like the one using a compound semiconductor or the one using an organic material. Currently most solar cells use a silicon crystal.

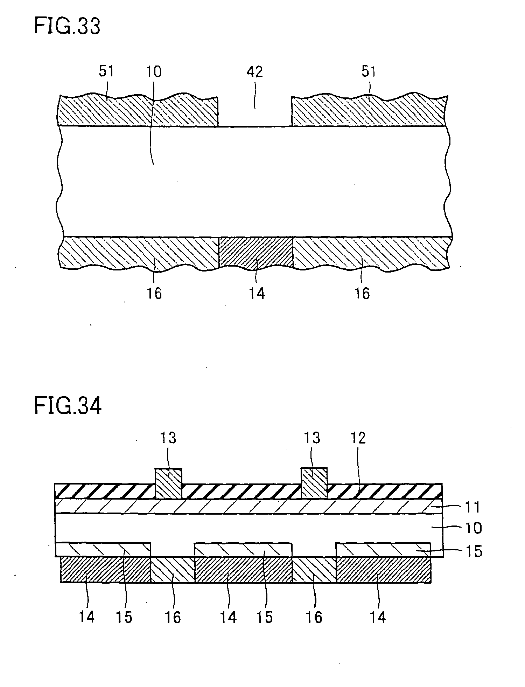

Fig. 34 shows a schematic cross section of an example of conventional solar cells. Here, the solar cell includes a p-type silicon substrate 10 made of a single-crystal silicon or polycrystalline silicon and an n+ layer 11 formed at a light-receiving surface of p-type silicon substrate 10. P-type silicon substrate 10 and n+ layer 11 thus form a pn junction. On the light-receiving surface of p-type silicon substrate 10, an antireflection film 12 and a silver electrode 13 are formed. At the rear surface opposite to the light-receiving surface of p-type silicon substrate 10, a p+ layer 15 is formed. On the rear surface of p-type silicon substrate 10, an aluminum electrode 14 and a silver electrode 16 are formed.

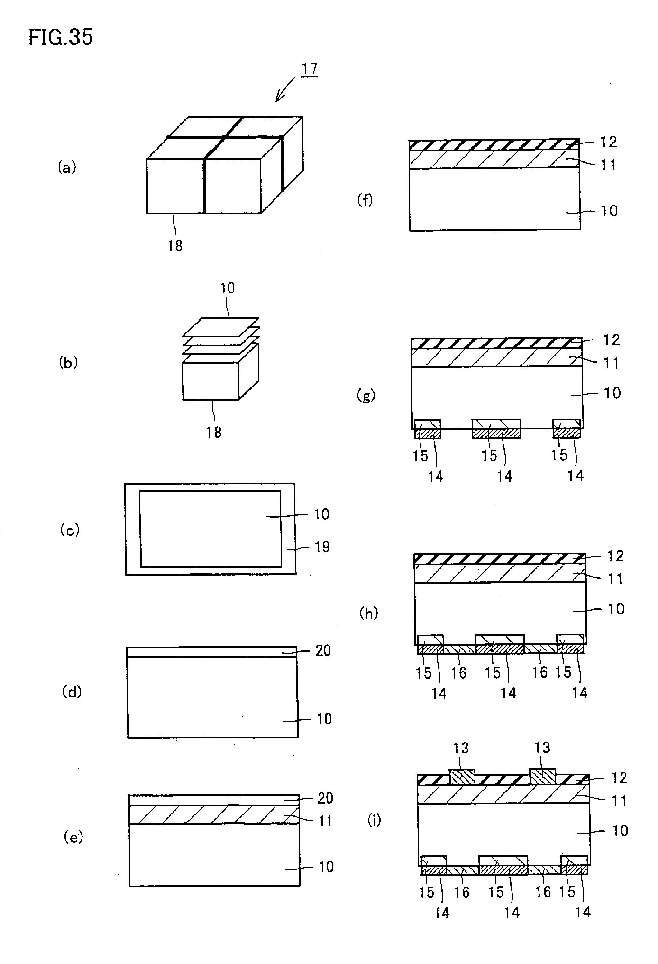

In Fig. 35 (a) to (i), an example of a method of manufacturing the conventional solar cell is shown. First, as shown in Fig. 35 (a), a silicon ingot 17 that is produced by dissolving a material for a p-type silicon crystal in a crucible and thereafter recrystallizing the material is cut into silicon blocks 18. Next, as shown in Fig. 35 (b), a silicon block 18 is cut with a wire saw to produce p-type silicon substrate 10.

Then, an alkali or acid is used to etch a surface of p-type silicon substrate 10, thereby removing a damage layer 19 generated in the slicing process of p-type silicon substrate 10 as shown in Fig. 35 (c). At this time, etching conditions may be adjusted to form microscopic asperities (not shown) at the surface of p-type silicon substrate 10. The asperities can reduce reflection of sunlight incident on the surface of p-type silicon substrate 10 and thereby improve the photovoltaic conversoin efficiency of the solar cell.

Subsequently, as shown in Fig. 35 (d), on one main surface (hereinafter referred to as "first main surface") of p-type silicon substrate 10, a dopant solution 20 is applied that contains a compound including phosphorous. P-type silicon substrate 10 on which dopant solution 20 has been applied is heat-treated at a temperature of 800°C to 950°C for 5 to 30 minutes to cause the phosphorus which is an n-type dopant to be diffused in the first main surface of p-type silicon substrate 10. Accordingly, as shown in Fig. 35 (e), n+ layer 11 is formed at the first main surface of p-type silicon substrate 10. Note that the method of forming n+ layer 11 includes the method applying the dopant solution and additionally a method by means of vapor phase diffusion using P₂O₅ or POCl₃.

Then, a glass layer formed at the first main surface of p-type silicon substrate 10 when the phosphorus is diffused is removed by an acid treatment. After this, as shown in Fig. 35 (f), antireflection film 12 is formed on the first main surface of p-type silicon substrate 10. The method of forming antireflection film 12 is known to include a method using a normal pressure CVD method to form a titanium oxide film and a method using a plasma CVD method to form a silicon nitride film. In the case where the method applying the dopant solution is used to diffuse phosphorus, a dopant solution containing a material for antireflection film 12 in addition to phosphorus may be used to simultaneously form n+ layer 11 and antireflection film 12. Further, in some cases, antireflection film 12 is formed after the silver electrode is formed.

Next, as shown in Fig. 35 (g), on the other main surface (hereinafter referred to as "second main surface") of p-type silicon substrate 10, aluminum electrode 14 is formed. Further, p+ layer 15 is formed at the second main surface of p-type silicon substrate 10. As for aluminum electrode 14 and p+ layer 15, an aluminum paste composed for example of an aluminum powder, a glass frit, a resin and an organic solvent is used to print the second main surface of p-type silicon substrate 10 by means of screen printing for example, and thereafter p-type silicon substrate 10 is heat-treated to cause aluminum to dissolve and generate an alloy with silicon, thereby forming an aluminum-silicon alloy layer and, under the alloy layer, p+ layer 15 is formed. Further, aluminum electrode 14 is formed on the second main surface of p-type silicon substrate 10. A dopant density difference between p-type silicon substrate 10 and p+ layer 15 causes a potential difference (acting as a potential barrier) at the interface between p-type silicon substrate 10 and p+ layer 15, which prevents optically generated carriers from recoupling around the second main surface of p-type silicon substrate 10. Accordingly, the short-circuit current (Isc) and the open circuit voltage (Voc) of the solar cell are both improved.

After this, as shown in Fig. 35 (h), on the second main surface of p-type silicon substrate 10, silver electrode 16 is formed. Silver electrode 16 can be obtained by using a silver paste composed for example of a silver powder, a glass frit, a resin and an organic solvent to print by means of screen printing for example and thereafter heat treating p-type silicon substrate 10.

Then, as shown in Fig. 35 (i), on the first main surface of p-type silicon substrate 10, silver electrode 13 is formed. As for silver electrode 13, in order to keep low a series resistance including a contact resistance with p-type silicon substrate 10 and to prevent reduction of the amount of incident sunlight by decreasing the area where silver electrode 13 is formed, a pattern design for the line width, pitch and thickness for example of silver electrode 13 is important. As for a method of forming silver electrode 13, for example, on the surface of antireflection film 12, a silver paste composed for example of a silver powder, a glass frit, a resin and an organic solvent is used to print by means of screen printing for example, and p-type silicon substrate 10 is thereafter heat-treated to allow the silver paste to extend through antireflection film 12 and have a good electrical contact with the first main surface of p-type silicon substrate 10. This fire through process is used in a mass production line.

In this way, the solar cell structured as shown in Fig. 34 can be manufactured. Note that, after silver electrode 13 and silver electrode 16 are formed, p-type silicon substrate 10 may be immersed in a molten solder bath to coat the surfaces of silver electrode 13 and silver electrode 16 with the solder. The solder coating may not be performed depending on the process. Further, the solar cell manufactured in the above-described manner may be irradiated with pseudo sunlight using a solar simulator to measure a current-voltage (IV) characteristic of the solar cell and examine the IV characteristic.

In most cases, a plurality of solar cells are connected in series to form a solar cell string, and the solar cell string is sealed with a sealing material to produce a solar cell module for sale and use.

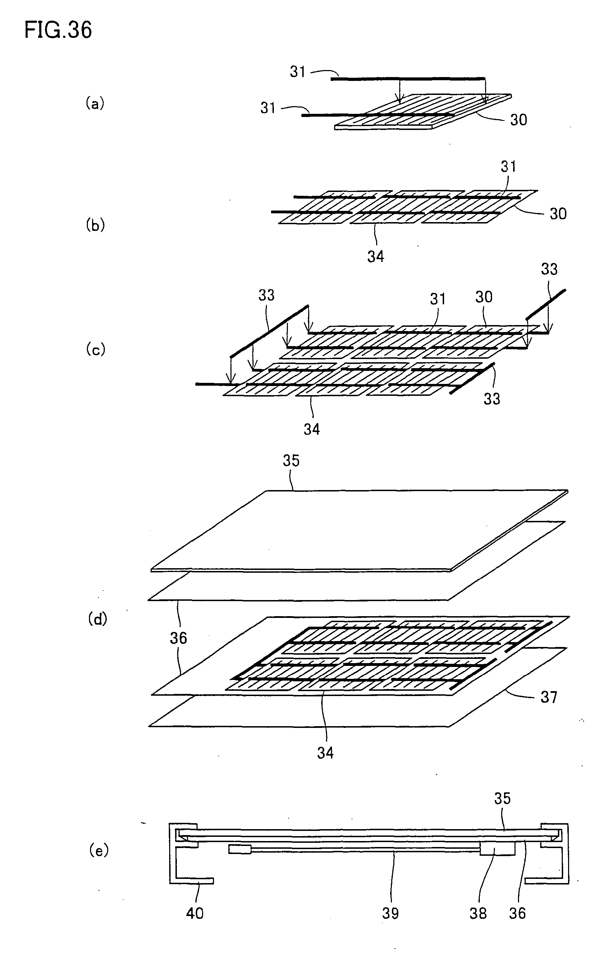

In Fig. 36 (a) to (e), an example of a method of manufacturing a conventional solar cell module is shown. First, as shown in Fig. 36 (a), on a silver electrode of a first main surface of a solar cell 30, an interconnector 31 which is an electrically conductive member is connected to produce interconnector-equipped solar cell 30.

Next, as shown in Fig. 36 (b), interconnector-equipped solar cells 30 to which inter connectors 31 1 are connected are arranged in a line. Interconnector 31 has one end connected to the silver electrode of the first main surface of solar cell 30 and has the other end connected to the silver electrode of the second main surface of another solar cell 30 to produce a solar cell string 34.

Then, as shown in Fig. 36 (c), solar cell strings 34 are arranged, and interconnectors 31 projecting from the two opposing ends of solar cell string 34 and interconnectors 31 projecting from the two opposing ends of another solar cell string 34 are connected in series by means of a wire material 33 which is an electrically conductive member to connect solar cell strings 34 to each other.

Subsequently, as shown in Fig. 36 (d), connected solar cell strings 34 are sandwiched between EVA (ethylene vinyl acetate) films 36 serving as a sealing member, and thereafter sandwiched between a glass plate 35 and a back film 37. Air bubbles entering between EVA films 36 are removed by reducing the pressure. Heat treatment is performed to harden EVA films 36 and thereby seal the solar cell strings in the EVA. In this way, the solar cell module is produced.

After this, as shown in Fig. 36 (e), the solar cell module is disposed in an aluminum frame 40, and a terminal box 38 equipped with a cable 39 is attached to the solar cell module. Then, the solar cell module manufactured in the above-described manner is irradiated with pseudo sunlight using a solar simulator to measure a current-voltage (IV) characteristic and examine the IV characteristic.

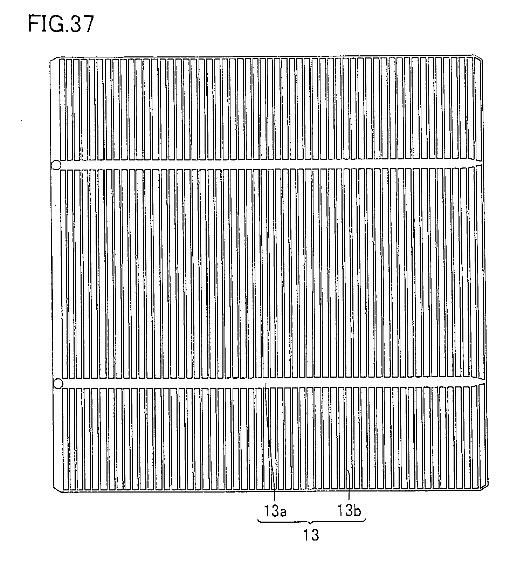

Fig. 37 shows a schematic plan view of electrodes formed at the light-receiving surface of the solar cell shown in Fig. 34. Here, at the first main surface of p-type silicon substrate 10 that is the light-receiving surface of the solar cell, silver electrode 13 is formed. Silver electrode 13 includes one linear bus bar electrode 13a of a relatively large width and a plurality of linear finger electrodes 13b of a relatively small width extending from bus bar electrode 13a.

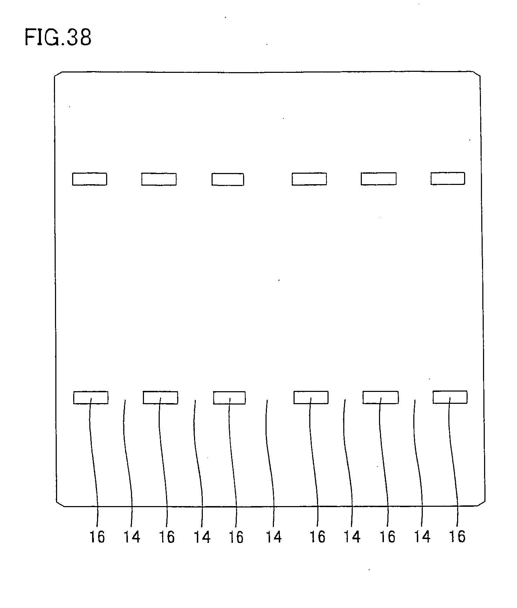

Fig. 38 shows a schematic plan view of electrodes formed at the rear surface of the solar cell shown in Fig. 34. Here, aluminum electrode 14 is formed over a substantially entire part of the second main surface of p-type silicon substrate 10 that is the rear surface of the solar cell, while silver electrode 16 is formed over only a part of the second main surface of p-type silicon substrate 10. This is for the following reason. It is difficult to coat aluminum electrode 14 with a solder and thus silver electrode 16 which can be coated with a solder may be necessary in some cases.

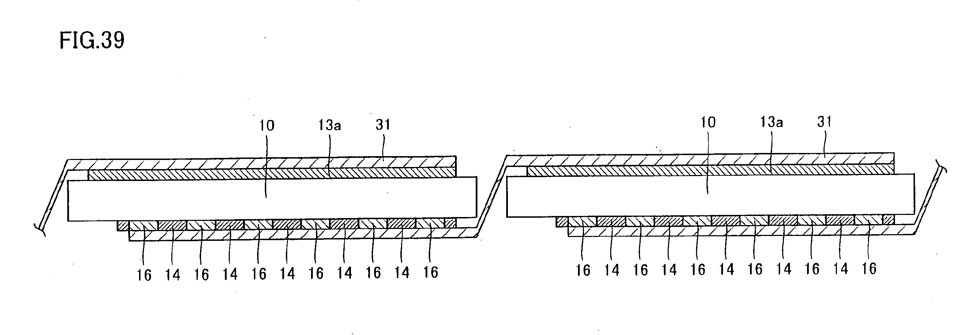

Fig. 39 shows a schematic cross section of a solar cell string in which solar cells structured as shown in Fig. 34 are connected in series. Interconnector 31 which is secured with a solder for example to bus bar electrode 13 a at the light-receiving surface of a solar cell is secured with a solder for example to silver electrode 16 on the rear surface of another solar cell adjacent thereto. In Fig. 39, the n+ layer and the p+ layer are not shown. Patent Document 1: Japanese Patent Laying-Open No. 2005-142282

### DISCLOSURE OF THE INVENTION

### PROBLEMS TO BE SOLVED BY THE INVENTION

As photovoltaic power generation systems become rapidly widespread, reduction of the manufacturing cost of the solar cell becomes indispensable. For reducing the manufacturing cost of the solar cell, it is significantly effective to increase the size and reduce the thickness of a silicon substrate which is a semiconductor substrate. The increase in size and reduction in thickness of the silicon substrate, however, is accompanied by the following problem. In the process of forming an interconnector-equipped solar cell or a solar cell string, an electrode (bus bar electrode, silver electrode) of the solar cell and an interconnector of copper are secured and connected to each other with a solder in a heating process. In a subsequent cooling process, a difference in thermal expansion coefficient between the silicon substrate of the solar cell and the interconnector (silicon has a thermal expansion coefficient of 3.5 × 10⁻⁶ /K while copper has a thermal expansion coefficient of 17.6 × 10⁻⁶ /K and the latter is approximately five times as large as the former) causes a large internal stress between the silicon substrate and the interconnector, resulting in the problem that the solar cell is greatly warped.

Specifically, the electrode of the solar cell and the interconnector are secured in the heating process and thereafter the heated electrode of the solar cell and the heated interconnector are cooled to a room temperature. At this time, the interconnector contracts to a greater degree than the solar cell to cause the solar cell to warp in a concave shape. The generated warp of the solar cell causes a transfer error and cracking of the solar cell in a transfer system of an automated manufacturing line for solar cell modules. Further, in the case where the solar cell is warped, a strong local force is exerted on each of solar cells constituting a solar cell string in a sealing process using a sealing material for manufacturing a solar cell module, which causes the solar cell to crack.

For example, Japanese Patent Laying-Open No. 2005-142282 (Patent Document 1) discloses a method according to which a small cross-sectional area portion where the cross-sectional area is locally smaller is provided to an interconnector connecting solar cells adjacent to each other. As described above, when the interconnector and the solar cell that are heated in the heating process are then cooled to a room temperature, the solar cell is warped in a concave shape. At this time, the solar cell is given the ability to recover its original shape (resilience) and the resilience applies a tensile stress to the interconnector. According to the method disclosed in Patent Document 1, when the tensile stress is applied to the interconnector, the small cross-sectional area portion having a relatively small strength compared with the other portion extends to reduce the warp of the solar cell. Further improvements, however, are desired.

An object of the present invention is therefore to provide a solar cell for which a warp of the solar cell caused after an interconnector is connected can be reduced, an interconnector-equipped solar cell, a solar cell string and a solar cell module using the solar cell.

### MEANS FOR SOLVING THE PROBLEMS

The present invention is a solar cell including a semiconductor substrate having a first main surface, a bus bar electrode and a plurality of linear finger electrodes extending from the bus bar electrode being provided on the first main surface, the bus bar electrode including a first connecting portion to be connected to an interconnector and a first non-connecting portion without connected to the interconnector, and the first connecting portion and the first non-connecting portion being arranged alternately.

Here, in the solar cell of the present invention, on a second main surface opposite to the first main surface of the semiconductor substrate, a second connecting portion to be connected to the interconnector and a second non-connecting portion without connected to the interconnector may be alternately arranged.

Further, in the solar cell of the present invention, the first connecting portion and the second connecting portion are preferably disposed at respective positions symmetrical to each other with respect to the semiconductor substrate.

Further, in the solar cell of the present invention, preferably the first non-connecting portion located between the first connecting portions adjacent to each other has a length longer than the length of the second non-connecting portion located between the second connecting portions adjacent to each other, or the second non-connecting portion located between the second connecting portions adjacent to each other has a length longer than the first non-connecting portion located between the first connecting portions adjacent to each other. Here, regarding the present invention, "length" refers to the length in the direction in which the first connecting portion and the first non-connecting portion are alternately arranged.

Further, in the solar cell of the present invention, the first connecting portion may be linearly formed.

Further, in the solar cell of the present invention, the bus bar electrode may have a hollow pattern portion including the first non-connecting portion.

Further, in the solar cell of the present invention, the bus bar electrode in the hollow pattern portion may have a width smaller than the width of the bus bar electrode in the first connecting portion.

Further, in the solar cell of the present invention, preferably the bus bar electrode includes a plurality of the hollow pattern portions, and the hollow pattern portions adjacent to each other are at regular intervals.

Further, in the solar cell of the present invention, at least one of a distance between an end of the first main surface and the hollow pattern portion adjacent to this end of the first main surface and a distance between another end of the first main surface and the hollow pattern portion adjacent to this another end is smaller than a distance between the hollow pattern portions adjacent to each other.

Further, in the solar cell of the present invention, at least one of the first connecting portions adjacent respectively to ends of the first main surface may be disposed apart from the end of the first main surface.

Further, the present invention is an interconnector-equipped solar cell including an interconnector connected to the first connecting portion of the solar cell as described above.

Here, in the interconnector-equipped solar cell of the present invention, preferably the interconnector includes a small cross-sectional area portion where a cross-sectional area of a cross section perpendicular to a longitudinal direction of the interconnector is locally small, and the small cross-sectional area portion is disposed at the first non-connecting portion.

Further, in the interconnector-equipped solar cell of the present invention, the interconnector may include a plurality of the small cross-sectional area portions and a non-small cross-sectional area portion located between the small cross-sectional area portions, and the non-small cross-sectional area portion may be disposed at the first non-connecting portion.

Further, in the interconnector-equipped solar cell of the present invention, on a second main surface opposite to the first main surface of the semiconductor substrate, a second connecting portion to be connected to the interconnector and a second non-connecting portion without connected to the interconnector may be arranged alternately.

Further, the present invention is a solar cell string including a plurality of solar cells connected to each other, the solar cell including: a bus bar electrode having a first connecting portion to be connected to an interconnector and a first non-connecting portion without connected to the interconnector, the first connecting portion and the first non-connecting portion being arranged alternately on a first main surface of a semiconductor substrate; a plurality of linear finger electrodes extending from the bus bar electrode; a second connecting portion to be connected to the interconnector; and a second non-connecting portion without connected to the interconnector, the second connecting portion and the second non-connecting portion being arranged alternately on a second main surface opposite to the first main surface of the semiconductor substrate. The first connecting portion of a first solar cell and the second connecting portion of a second solar cell adjacent to the first solar cell are connected to the interconnector.

Here, in the solar cell string of the present invention, the interconnector may be bent at an end of the first solar cell and an end of the second solar cell.

Further, in the solar cell string of the present invention, preferably the interconnector includes a small cross-sectional area portion where a cross-sectional area of a cross section perpendicular to a longitudinal direction of the interconnector is locally small, and the small cross-sectional area portion is disposed in at least one of a portion corresponding to the first non-connecting portion of the first solar cell and a portion corresponding to the second non-connecting portion of the second solar cell.

Further, in the solar cell string of the present invention, preferably the interconnector includes a small cross-sectional area portion where a cross-sectional area of a cross section perpendicular to a longitudinal direction of the interconnector is locally small, and the small cross-sectional area portion is disposed in all of a portion corresponding to the first non-connecting portion of the first solar cell and a portion corresponding to the second non-connecting portion of the second solar cell.

Further, the present invention is a solar cell string including a plurality of solar cells connected to each other, the solar cell including: a bus bar electrode including a first connecting portion to be connected to an interconnector and a hollow pattern portion having a first non-connecting portion without connected to the interconnector, the first connecting portion and the hollow pattern portion being arranged alternately on a first main surface of a semiconductor substrate; a plurality of linear finger electrodes extending from the bus bar electrode; a second connecting portion to be connected to the interconnector; and a second non-connecting portion without connected to the interconnector, the second connecting portion and the second non-connecting portion being arranged alternately on a second main surface opposite to the first main surface of the semiconductor substrate. The first connecting portion of a first solar cell and the second connecting portion of a second solar cell adjacent to the first solar cell are connected to the interconnector.

Here, in the solar cell string of the present invention, preferably the interconnector includes a small cross-sectional area portion where a cross-sectional area of a cross section perpendicular to a longitudinal direction of the interconnector is locally small, and the small cross-sectional area portion is disposed in at least one of a portion corresponding to the hollow pattern portion of the first solar cell and a portion corresponding to the second non-connecting portion of the second solar cell.

Further, in the solar cell string of the present invention, preferably the interconnector includes a small cross-sectional area portion where a cross-sectional area of a cross section perpendicular to a longitudinal direction of the interconnector is locally small, and the small cross-sectional area portion is disposed in all of a portion corresponding to the hollow pattern portion of the first solar cell and a portion corresponding to the second non-connecting portion of the second solar cell.

Further, the present invention is a solar cell module including any of the above-described solar cell strings sealed with a sealing material.

### EFFECTS OF THE INVENTION

According to the present invention, a solar cell, an interconnector-equipped solar cell, a solar cell string, and a solar cell module can be provided for which a warp caused when an interconnector is connected can be reduced.

### BRIEF DESCRIPTION OF THE DRAWINGS

Fig. 1 (a) is a schematic plan view of an example of electrodes formed at a light-receiving surface of a solar cell of the present invention, and (b) is a schematic enlarged plan view of a first non-connecting portion and therearound shown by (a).
Fig. 2 is a schematic plan view of an example of electrodes formed at a rear surface of the solar cell.
Fig. 3 is a schematic cross section of an example of a solar cell string in which solar cells are connected in series, the solar cells including the electrodes on the light-receiving surface side as shown in Fig. 1 (a) and the electrodes on the rear surface side as shown in Fig. 2.
Fig. 4 is a schematic enlarged plan view of the solar cell string shown in Fig. 3 as seen from the light-receiving surface side.
Fig. 5 is a schematic plan view of an example of a solar cell string of the present invention as seen from the light-receiving surface side of the solar cell.
Fig. 6 is a schematic cross section of the solar cell string shown in Fig. 5.
Fig. 7 is a schematic enlarged plan view of a state where an example of an interconnector used for the present invention is connected.
Fig. 8 is a schematic enlarged plan view of a state where another example of the interconnector used for the present invention is connected.
Fig. 9 is a schematic plan view of an example of the interconnector used for the present invention.
Fig. 10 (a) is a schematic plan view of another example of the interconnector used for the present invention, (b) is a schematic side view of the interconnector shown by (a), and (c) is a schematic front view of the interconnector shown by (a).
Fig. 11 (a) is a schematic plan view of still another example of the interconnector used for the present invention, (b) is a schematic side view of the interconnector shown by (a), and (c) is a schematic front view of the interconnector shown by (a).
Fig. 12 (a) is a schematic plan view of a further example of the interconnector used for the present invention, (b) is a schematic side view of the interconnector shown by (a), and (c) is a schematic front view of the interconnector shown by (a).
Fig. 13 is a schematic cross section of an example of a solar cell string structured using the interconnector shown in Fig. 9.
Fig. 14 is a schematic enlarged plan view of the solar cell string shown in Fig. 13 as seen from the light-receiving surface side of the solar cell.
Fig. 15 is a schematic plan view of an example of the interconnector used for the present invention.
Fig. 16 is a schematic plan view of an example of electrodes formed at the light-receiving surface of a solar cell used for forming a solar cell string using the interconnector shown in Fig. 15.
Fig. 17 is a schematic plan view of an example of electrodes formed at the rear surface of the solar cell used for forming the solar cell string using the interconnector shorn in Fig. 15.
Fig. 18 is a schematic cross section of an example of a solar cell string in which solar cells having the electrodes on the light-receiving surface side as shown in Fig. 16 and the electrodes on the rear surface side as shown in Fig. 17 are connected in series using the interconnector shown in Fig. 15.
Fig. 19 is a schematic enlarged plan view of the solar cell string shown in Fig. 18 as seen from the light-receiving surface of the solar cell.
Fig. 20 is a schematic plan view of an example of electrodes formed at the light-receiving surface of a solar cell used for an interconnector-equipped solar cell of the present invention.
Fig. 21 is a schematic plan view of an example of electrodes formed at the rear surface of the solar cell used for the interconnector-equipped solar cell of the present invention.
Fig. 22 is a schematic plan view of a preferred example of an interconnector used for the interconnector-equipped solar cell of the present invention.
Fig. 23 is a schematic enlarged plan view of the light-receiving surface of a preferred example of the interconnector-equipped solar cell of the present invention.
Fig. 24 is a schematic cross section of the interconnector-equipped solar cell of the present invention shown in Fig. 23.
Fig. 25 is a schematic cross section of a preferred example of the solar cell string of the present invention.
Fig. 26 is a schematic enlarged plan view of the light-receiving surface of the solar cell string of the present invention as shown in Fig. 25.
Fig. 27 is a schematic plan view of an example electrodes formed at the light-receiving surface of the solar cell of the present invention.
Fig. 28 is a schematic plan view of an example of electrodes formed at the rear surface of the solar cell of the present invention.
Fig. 29 is a schematic cross section of an example of a solar cell string in which solar cells including the electrodes on the light-receiving surface side as shown in Fig. 27 and the electrodes on the rear surface side as shown in Fig. 28 are connected in series using an interconnector.
Fig. 30 is a schematic plan view of an example of the interconnector used for the present invention.
Fig. 31 is a schematic cross section of another example of the solar cell string of the present invention.
Fig. 32 is a schematic cross section of still another example of the solar cell string of the present invention.
Fig. 33 is a schematic enlarged cross section of the solar cell string shown in Fig. 32.
Fig. 34 is a schematic cross section of an example of conventional solar cells.
Fig. 35 (a) to (i) are schematic diagrams showing an example of a method of manufacturing the conventional solar cell.
Fig. 36 (a) to (e) are schematic diagrams showing an example of a method of manufacturing a conventional solar cell module.
Fig. 37 is a diagram showing a pattern of silver electrodes formed at the light-receiving surface of the solar cell shown in Fig. 34
Fig. 38 is a schematic plan view of electrodes formed at the rear surface of the solar cell shown in Fig. 34.
Fig. 39 is a schematic cross section of a solar cell string in which solar cells structured as shown in Fig. 34 are connected in series.

### DESCRIPTION OF THE REFERENCE SIGNS

10 p-type silicon substrate, 11 n+ layer, 12 antireflection film, 13, 16 silver electrode, 13a bus bar electrode, 13b finger electrode, 14 aluminum electrode, 15 p+ layer, 17 silicon ingot, 18 silicon block, 19 damage layer, 20 dopant solution, 23 second bus bar electrode, 30 solar cell, 31 interconnector, 33 wire material, 34 solar cell string, 35 glass plate, 36 EVA film, 37 back film, 38 terminal box, 39 cable, 40 aluminum frame, 41 small cross-sectional area portion, 42 first non-connecting portion, 51 first connecting portion, 60 first interconnector-equipped solar cell, 62 second interconnector-equipped solar cell, 80 first solar cell, 81 second solar cell

### BEST MODES FOR CARRYING OUT THE INVENTION

In the following, embodiments of the present invention will be described. Regarding the present invention, like reference characters denote like or corresponding components.

### First Embodiment

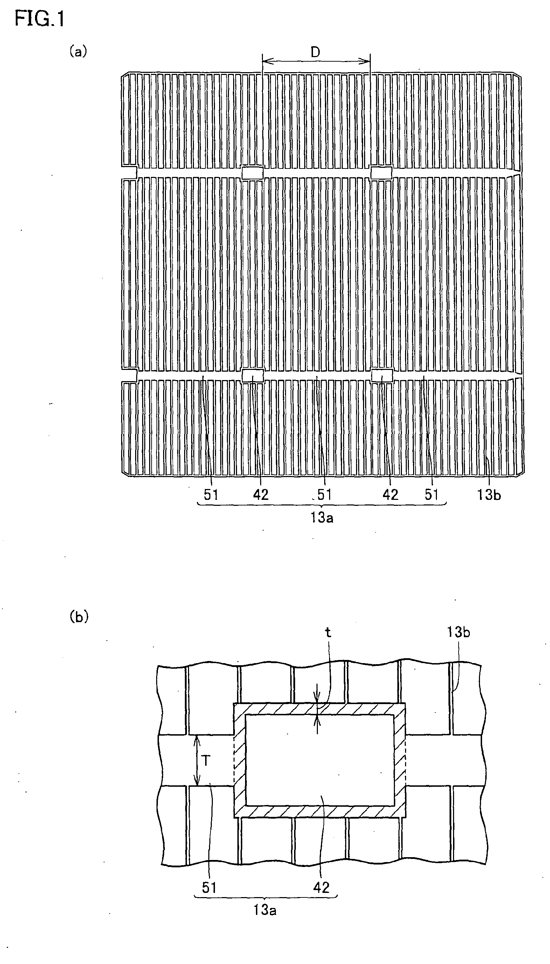

Fig. 1 (a) shows a schematic plan view of an example of electrodes formed at a light-receiving surface of a solar cell of the present invention. As shown in Fig. 1 (a), a first main surface of a p-type silicon substrate that is the light-receiving surface of the solar cell of the present invention is provided with a linear bus bar electrode 13a of a relatively large width extending laterally as seen on the drawing and a plurality of linear finger electrodes 13b of a relatively small width extending from bus bar electrode 13a longitudinally as seen on the drawing.

Bus bar electrode 13a includes a linear first connecting portion 51 to be secured and connected to an interconnector and a first non-connecting portion 42 that is a gap without connected to the interconnector. First connecting portion 51 and first non-connecting portion 42 are alternately arranged. Specifically, one bus bar electrode 13 a shown in Fig. 1 (a) includes three first connecting portions 51, and non-connecting portions 42 are disposed respectively between first connecting portions 51 adjacent to each other.

Fig. 1 (b) shows a schematic enlarged plan view of first non-connecting portion 42 and therearound shown in Fig. 1 (a). Bus bar electrode 13a has a hollow pattern portion where first non-connecting portion 42 which is a gap has its periphery surrounded by bus bar electrode 13a (hollow pattern portion: the portion composed of first non-connecting portion 42 which is a gap and a part (indicated by oblique lines in Fig. 1 (b)) of bus bar electrode 13a surrounding first non-connecting portion 42). While bus bar electrode 13a continues with a constant width in first connecting portion 51, bus bar electrode 13a in the hollow pattern portion has its width "t" smaller than its width "T" in first connecting portion 51, because the gap of first non-connecting portion 42 is formed to have a width larger than the width of bus bar electrode 13a in first connecting portion 51.

In the case where bus bar electrode 13 a has a plurality of hollow pattern portions, it is preferable that intervals between hollow pattern portions adjacent to each other are regular intervals. The interval between hollow pattern portions adjacent to each other refers to the shortest distance D between respective ends of first non-connecting portions 42 of respective hollow pattern portions adjacent to each other for example as shown in Fig. 1 (a). Further, "regular intervals" refer to the fact that the absolute value of the difference between the largest interval and the smallest interval among all intervals between hollow pattern portions adjacent to each other is not more than 0.5 mm.

Preferably, at least one of the interval between an end of the first main surface of the p-type silicon substrate and a hollow pattern portion adjacent to the end of the first main surface of the p-type silicon substrate and the interval between another end of the first main surface of the p-type silicon substrate and a hollow pattern portion adjacent to this another end of the first main surface of the p-type silicon substrate is smaller than the interval between hollow pattern portions adjacent to each other. Here, "end" refers to the end in the direction in which the first connecting portion and the first non-connecting portion are alternately arranged. Further, "the interval between an (another) end of the first main surface of the p-type silicon substrate and a hollow pattern portion adjacent to the (this another) end of the first main surface of the p-type silicon substrate" refers to the shortest distance between the end of the first main surface of the p-type silicon substrate and the end of first non-connecting portion 42 of the hollow pattern portion adjacent to the end of the first main surface.

First connecting portion 51 adjacent to an end of the first main surface of the p-type silicon substrate may be disposed apart from the end of the first main surface of the p-type silicon substrate.

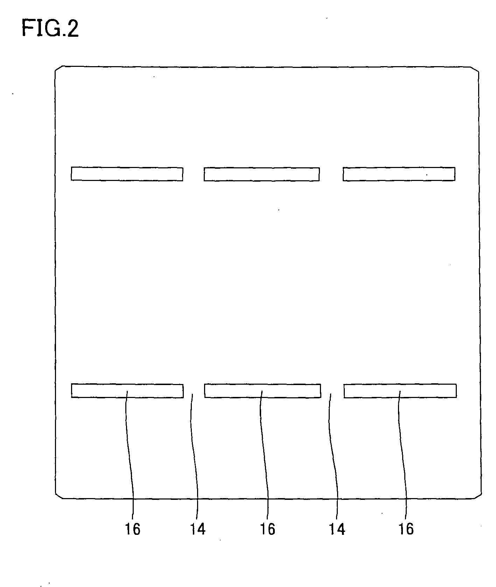

Fig. 2 shows a schematic plan view of an example of electrodes formed at the rear surface of the solar cell of the present invention. As shown in Fig. 2, at a second main surface of the p-type silicon substrate that is the rear surface of the solar cell of the present invention, a silver electrode 16 that is a second connecting portion to be connected to an interconnector and an aluminum electrode 14 that is a second non-connecting portion without connected to the interconnector are alternately arranged. The second non-connecting portion is aluminum electrode 14 between silver electrodes 16 adj acent to each other.

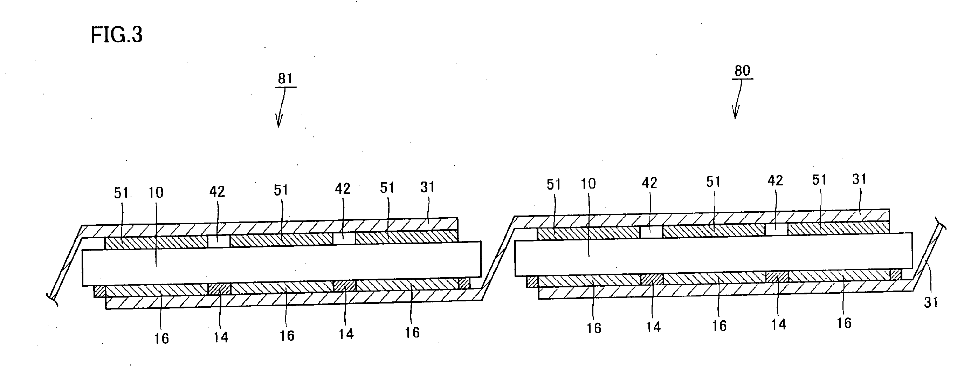

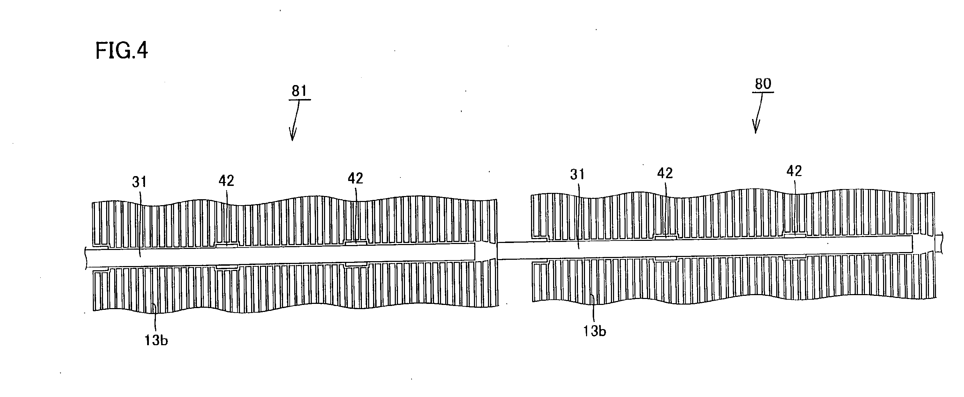

Fig. 3 shows a schematic cross section of an example of a solar cell string of the present invention, including solar cells connected in series that have the electrodes on the light-receiving surface side as shown in Fig. 1 (a) and the electrodes on the rear surface side as shown in Fig. 2. Fig. 4 shows a schematic enlarged plan view of the solar cell string shown in Fig. 3 as seen from the light-receiving surface side. Regarding a first solar cell 80 and a second solar cell 81 adjacent to each other, first connecting portion 51 of first solar cell 80 and silver electrode 16 that is the second connecting portion of second solar cell 81 are each secured and connected, with a solder for example, to the same interconnector 31 made of a single electrically conductive member. First non-connecting portion 42 and aluminum electrode 14 that is the second non-connecting portion of the solar cell are not secured to interconnector 31 and not connected to interconnector 31. Interconnector 31 is bent at an end of the solar cell (here, the end of first solar cell 80 and the end of second solar cell 81). In Fig. 3, the n+ layer and p+ layer are not shown. Silver electrode 16 that is the second connecting portion and first connecting portion 51 on the first main surface of the p-type silicon substrate are formed at respective positions symmetrically with respect to the p-type silicon substrate 10. For the present invention, an electrically conductive material for example may be used for the interconnector.

In the solar cell string of the present invention structured as described above, the length of connection between the interconnector and the first connecting portion of the solar cell can be reduced as compared with the conventional solar cell string. In the case where the length of connection between the interconnector and the first connecting portion of the solar cell is thus reduced, a stress due to a difference in thermal expansion coefficient between the interconnector and the p-type silicon substrate which is a component of the solar cell can be reduced. Further, since respective connecting portions on the light-receiving surface and the rear surface of the solar cell that connect the interconnector and the solar cell are symmetrically positioned with respect to the p-type silicon substrate, respective stresses generated at the light-receiving surface and the rear surface of the solar cell, which are caused by a difference in thermal expansion coefficient between the interconnector and the p-type silicon substrate of the solar cell are substantially equal to each other Therefore, in the solar cell string of the present invention, equal forces are exerted on the solar cell respectively from the light-receiving surface and the rear surface of the solar cell. With these effects, a warp of the solar cell due to connection of the interconnector can be reduced for the solar cells constituting the solar cell string.

Such a solar cell string of the present invention can be sealed with a sealing material such as EVA by a conventionally known method to obtain a solar cell module of the present invention.

### Second Embodiment

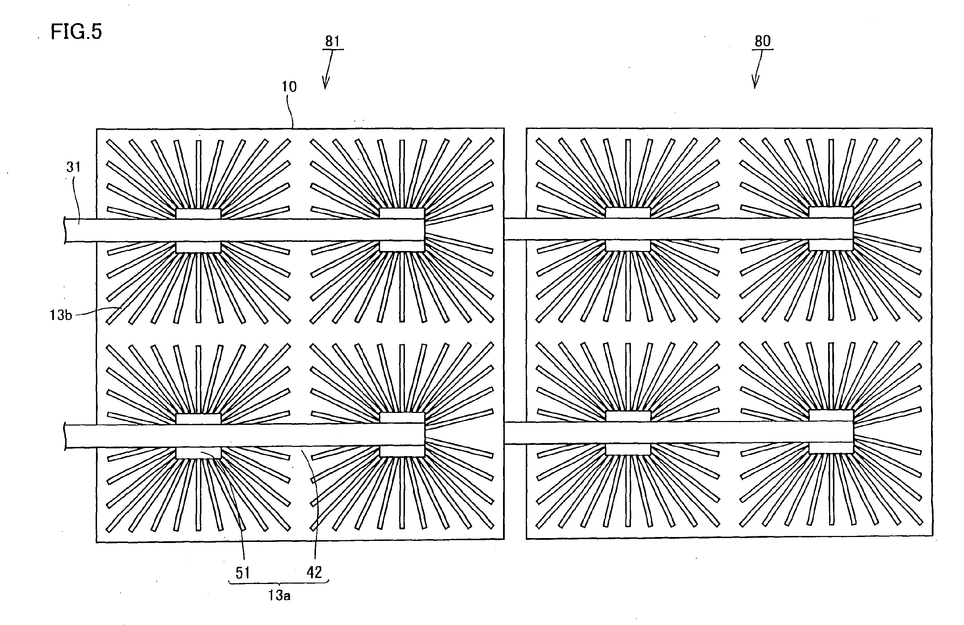

Fig. 5 shows a schematic plan view of an example of the solar cell string of the present invention as seen from the light-receiving surface side of the solar cell. On the first main surface of p-type silicon substrate 10 that is the light-receiving surface of the solar cell, a bus bar electrode 13a having an island-like first connecting portion 51 and a first non-connecting portion 42 that is a gap between first connecting portions 51 adjacent to each other as well as a plurality of linear finger electrodes 13b of a small width extending radially from bus bar electrode 13a are provided.

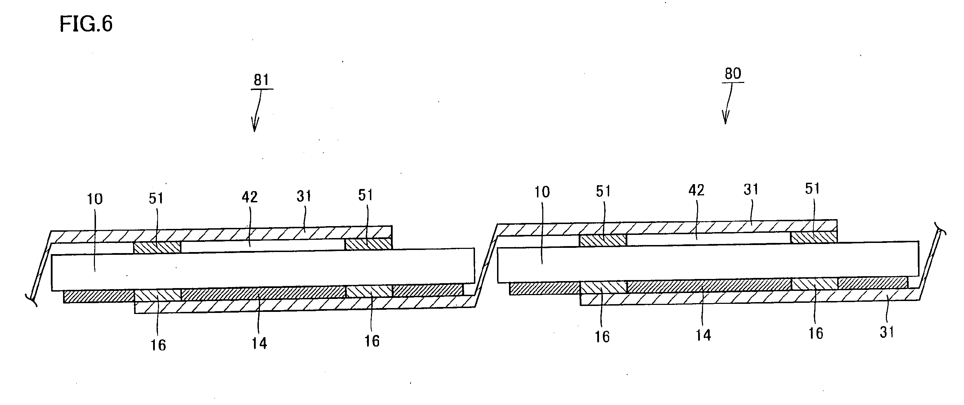

As shown in a schematic cross section of Fig. 6, in first solar cell 80 and second solar cell 81 adjacent to each other, first connecting portion 51 of first solar cell 80 and silver electrode 16 that is the second connecting portion of second solar cell 81 are secured and connected, with a solder for example, to the same interconnector 31 made of a single electrically conductive material.

Since first connecting portion 51 is provided as an island-like portion, the length of connection between the interconnector and the solar cell can be further reduced. Therefore, there is the tendency that the stress can further be reduced that is caused by a difference in thermal expansion coefficient between the interconnector and the p-type silicon substrate which is a component of the solar cell. Further, as shown in Fig. 6, silver electrode 16 which is the second connecting portion is formed at a position symmetrical to the first connecting portion 51 on the first main surface of p-type silicon substrate 10 with respect to p-type silicon substrate 10. Therefore, stresses generated due to a difference in thermal expansion coefficient between the interconnector and p-type silicon substrate 10 of the solar cell are substantially equal to each other at the light-receiving surface and the rear surface of the solar cell. Thus substantially equal forces are exerted on the solar cell respectively from the light-receiving surface and the rear surface of the solar cell. With these effects, a warp of the solar cell due to connection of the interconnector can be reduced for the solar cells constituting the solar cell string. Further, interconnector 31 is bent at an end of the solar cell (here, the end refers to the end of the first solar cell 80 and the end of the second solar cell 81). In Fig. 6, the n+ layer and the p+ layer are not shown.

Such a solar cell string of the present invention can be sealed with a sealing material such as EVA by a conventionally known method to obtain a solar cell module of the present invention.

### Third Embodiment

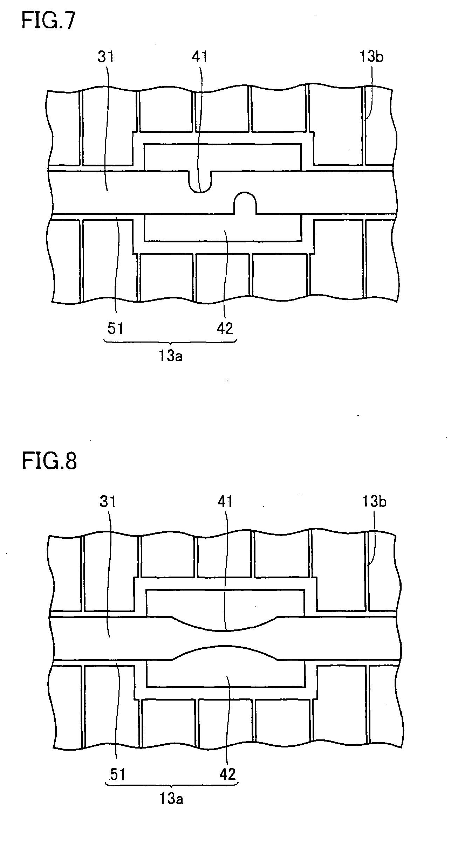

Fig. 7 shows a schematic enlarged plan view of the state where an example of the interconnector used for the present invention is connected. As shown in Fig. 7, a small cross-sectional area portion 41 where the cross-sectional area of interconnector 31 is locally smaller is disposed at a portion corresponding to first non-connecting portion 42. Small cross-sectional area portion 41 of interconnector 31 is formed by a notch made in a part of interconnector 31. Regarding the present invention, the cross-sectional area of the interconnector refers to the area of a cross section orthogonal to the longitudinal direction of the interconnector.

Fig. 8 shows a schematic enlarged plan view of the state where another example of the interconnector used for the present invention is connected. As shown in Fig. 8, a small sectional area portion 41 where the cross-sectional area of interconnector 31 is locally smaller is disposed at a portion corresponding to first non-connecting portion 42. Small cross-sectional area portion 41 of interconnector 31 is formed by a narrowed portion made in a part of interconnector 31.

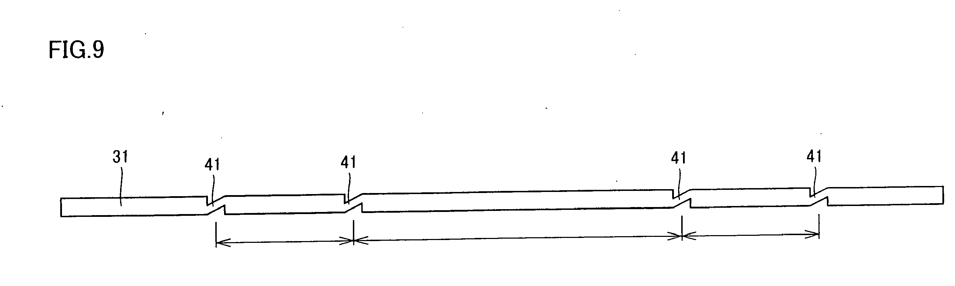

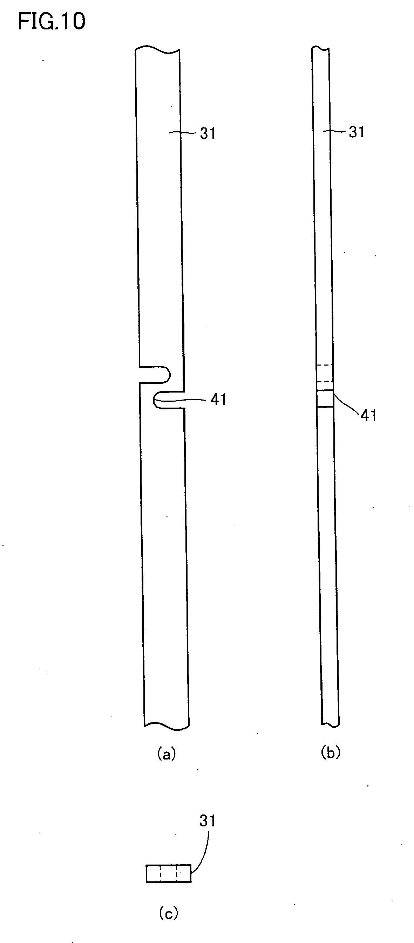

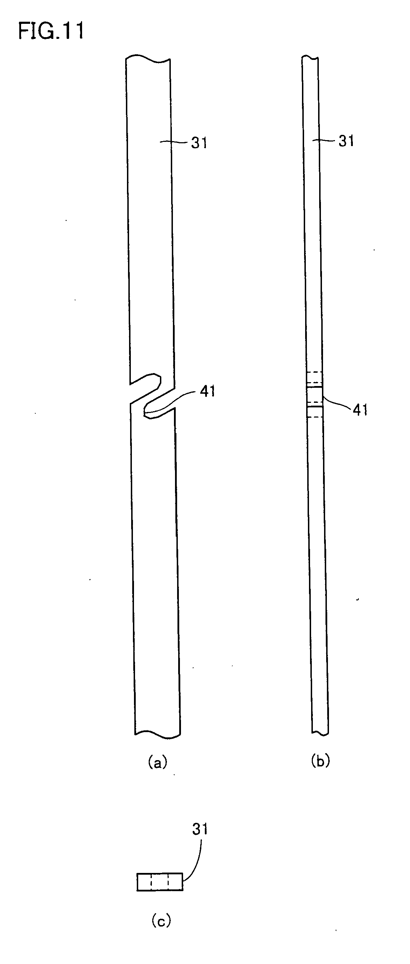

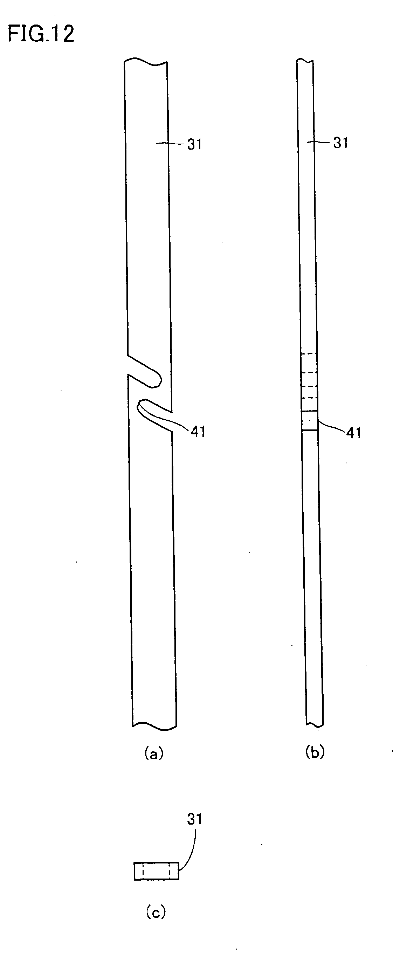

Fig. 9 shows a schematic plan view of an example of the interconnector used for the present invention. Fig. 10 (a) shows a schematic plan view of another example of the interconnector used for the present invention, Fig. 10 (b) shows a schematic side view of the interconnector shown in Fig. 10 (a) and Fig. 10 (c) shows a schematic front view of the interconnector shown in Fig. 10 (a). Fig. 11 (a) shows a schematic plan view of still another example of the interconnector used for the present invention, Fig. 11 (b) shows a schematic side view of the interconnector shown in Fig. 11 (a) and Fig. 11 (c) shows a schematic front view of the interconnector shown in Fig. 11 (a). Fig. 12 (a) shows a schematic plan view of an example of the interconnector used for the present invention, Fig. 12 (b) shows a schematic side view of the interconnector shown in Fig. 12 (a) and Fig. 12 (c) shows a schematic front view of the interconnector shown in Fig. 12 (a).

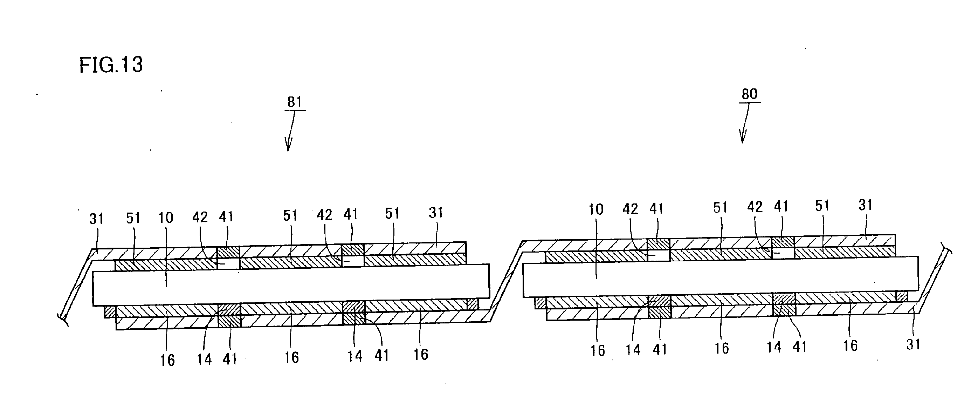

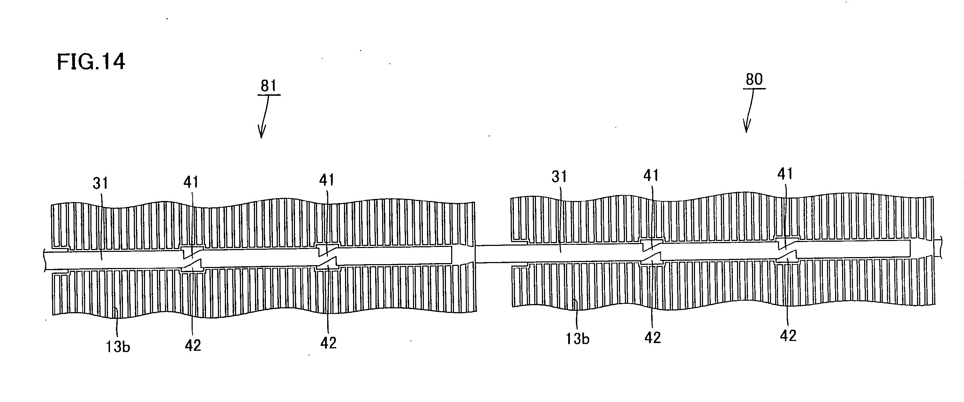

Fig. 13 shows a schematic cross section of an example of a solar cell string structured using the interconnector shown in Fig. 9. Fig. 14 shows a schematic plan view of the solar cell string shown in Fig. 13, as seen from the light-receiving surface side of the solar cell. In interconnector 31 shown in Fig. 9 in the connected state, small cross-sectional area portions 41 are respectively disposed, as shown in Figs. 9 and 13, at a portion corresponding first non-connecting portion 42 of first solar cell 80 (or at a portion corresponding to the hollow pattern portion), and at a portion corresponding to aluminum electrode 14 which is the second non-connecting portion of second solar cell 81. Namely, interconnector 31 is connected such that small cross-sectional area portions 41 of interconnector 31 are respectively disposed at a portion corresponding to first non-connecting portion 42 (or portion corresponding to the hollow pattern portion) and a portion corresponding to aluminum electrode 14 which is the second non-connecting portion.

As for the manner of disposing the small cross-sectional area portion of the interconnector at a portion corresponding to the first non-connecting portion (or portion corresponding to the hollow pattern portion), preferably as shown in Figs. 7 and 8 the whole of small cross-sectional area portion 41 of interconnector 31 is disposed to be included in the region of first non-connecting portion 42 (or region of the hollow pattern portion). However, small cross-sectional area 41 of interconnector 31 may be disposed such that only a part of the small cross-sectional area portion 41 is included in the region of first non-connecting portion 42 (or region of the hollow pattern portion). Further, as for the manner of disposing the small cross-sectional area portion of the interconnector at a portion corresponding to the second non-connecting portion, preferably the whole of the small cross-sectional area portion of the interconnector is included in the region of the second non-connecting portion as described above. However, the small cross-sectional area portion of the interconnector may be disposed such that only a part of the small cross-sectional area portion is included in the region of the second non-connecting portion.

Interconnector 31 is bent as shown in Fig. 13 at an end of the solar cell (here, the end of first solar cell 80 and the end of second solar cell 81). In Fig. 13, the n+ layer and p+ layer are not shown.

In the case where the interconnector having the small cross-sectional area portion as shown in Figs. 7 to 12 is used to form a solar cell string, in addition to the effect of reducing the length of connection between the interconnector and the solar cell and the effect that equal forces are exerted on the solar cell respectively from the light-receiving surface and the rear surface of the solar cell as described in connection with the first and second embodiments, there is additionally the effect of alleviating the internal stress when resilience of the solar cell is generated, since the small cross-sectional area portion extends that has a relatively smaller strength than other portions of the interconnector. Moreover, since the small cross-sectional area portions of the interconnector are disposed respectively at the first non-connecting portion and the second non-connecting portion, the small cross-sectional areas are not secured but in a free state, so that the small cross-sectional area portion can deform freely and thereby fully exhibit the stress alleviation effect obtained by the extension thereof. These effects allow the solar cell which is a component of the solar cell string to reduce the warp of the solar cell caused by connection of the interconnector. It is apparent that the present invention is not limited to the use of the interconnectors shown in Figs. 7 to 12.

In terms of exhibiting the stress alleviation effect of the present invention, it is preferable that the small cross-sectional area portion of the interconnector is provided in at least one of a portion corresponding to the first non-connecting portion and a portion corresponding to the second non-connecting portion. It is most preferable that respective small cross-sectional area portions are provided in all of portions corresponding to the first non-connecting portion and the second non-connecting portion.

In other words, in the above-described example, it is preferable that interconnector 31 is connected such that small cross-sectional area portion 41 of interconnector 31 is disposed in at least one of those portions corresponding to first non-connecting portion 51 of first solar cell 80 and those portions corresponding to aluminum electrode 14 that is the second non-connecting portion of second solar cell 81. It is most preferable that interconnector 31 is connected such that respective small cross-sectional area portions 41 of interconnector 31 are disposed in all of portions corresponding to first non-connecting portion 51 of first solar cell 80 and portions corresponding to aluminum electrode 14 that is the second non-connecting portion of second solar cell 81.

Such a solar cell string of the present invention can be sealed with a sealing material such as EVA by a conventionally known method to obtain a solar cell module of the present invention.

### Fourth Embodiment

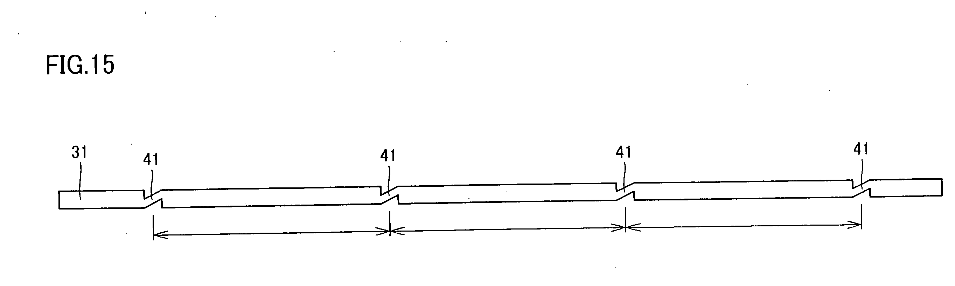

Fig. 15 shows a schematic plan view of an example of the interconnector used for the present invention. The intervals between small cross-sectional area portions 41 adjacent to each other of interconnector 31 shown in Fig. 15 are regular intervals.

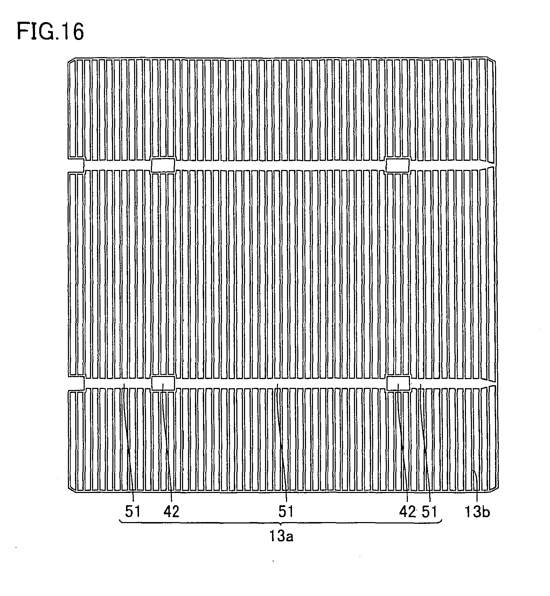

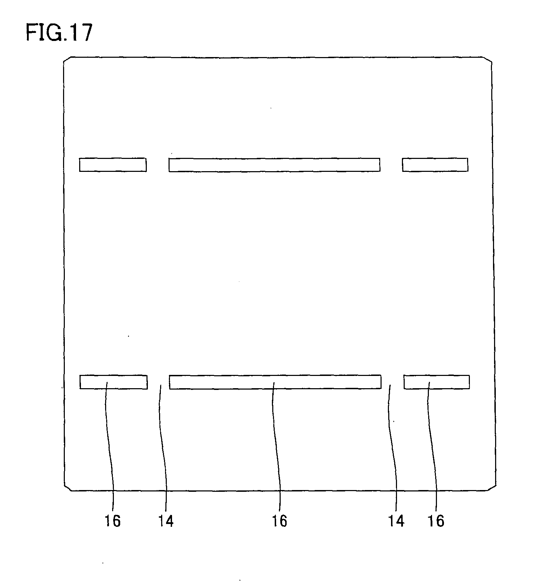

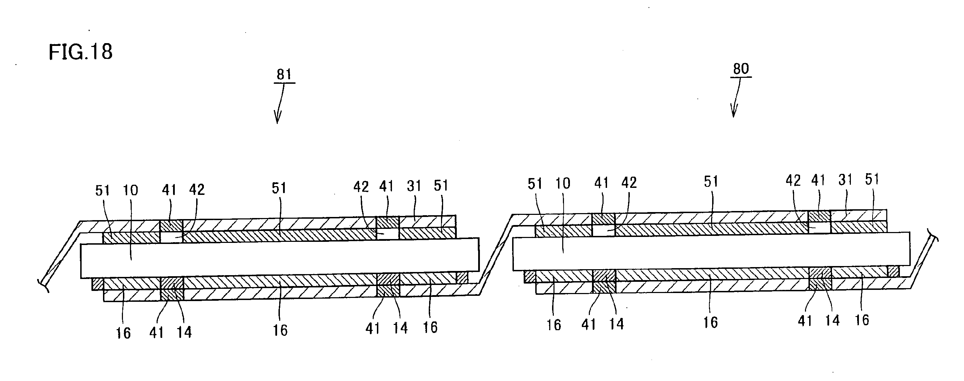

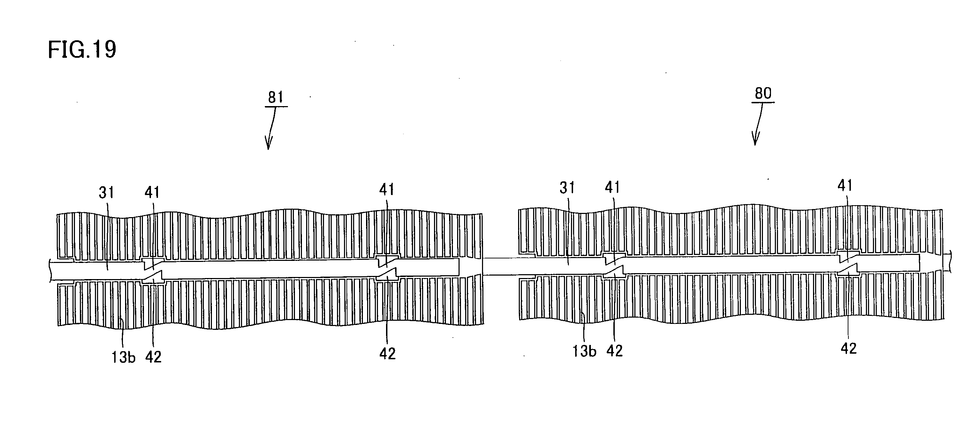

Fig. 16 shows a schematic plan view of an example of electrodes formed at the light-receiving surface of a solar cell used for forming a solar cell string using interconnector 31 shown in Fig. 15. Fig. 17 shows a schematic plan view of an example of electrodes formed at the rear surface of the solar cell used for forming the solar cell string using interconnector 31 shown in Fig. 15. Fig. 18 shows a schematic cross section of a solar cell string in which solar cells having the electrodes on the light-receiving surface side shown in Fig. 16 and the electrodes on the rear surface side shown in Fig. 17 are connected in series using interconnector 31 shown in Fig. 15. Fig. 19 shows a schematic enlarged plan view of the solar cell string shown in Fig. 18, as seen from the light-receiving surface of the solar cell. As shown in Fig. 18, interconnector 31 is bent at an end (here the end of first solar cell 80 and the end of second solar cell 81). In Fig. 18, the n+ layer and p+ layer are not shown.

In the case where interconnector 31 having small cross-sectional area portions adjacent to each other that are arranged at regular intervals as described above is used, small cross-sectional area portions 41 of interconnector 31 can be formed more easily. Thus, the manufacturing cost of the solar cell string is reduced and the productivity of the solar cell string can be improved.

Such a solar cell string of the present invention can be sealed with a sealing material such as EVA by a conventionally known method to obtain a solar cell module of the present invention.

### Fifth Embodiment

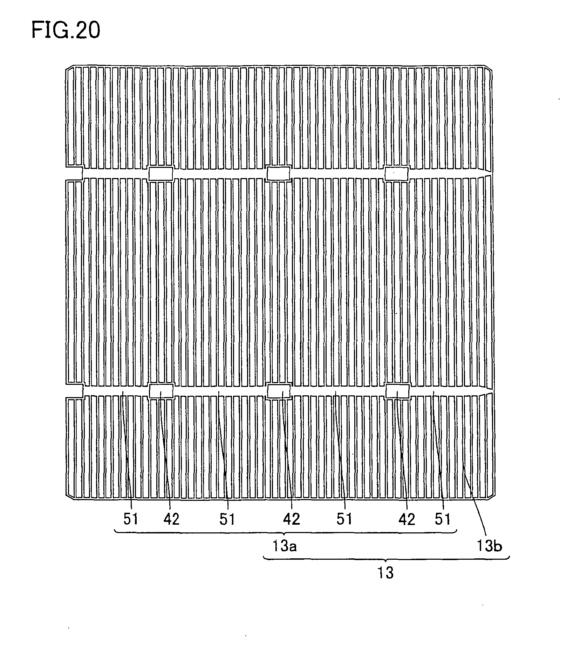

Fig. 20 shows a schematic plan view of an example of electrodes formed at the light-receiving surface of a solar cell used for an interconnector-equipped solar cell of the present invention. As shown in Fig. 20, at the first main surface of the p-type silicon substrate that is the light-receiving surface of the solar cell, a single linear bus bar electrode 13a of a relatively large width and a plurality of linear finger electrodes 13b of a relatively small width extending from bus bar electrode 13a constitute a silver electrode 13 as formed. Bus bar electrode 13a includes a linear first connecting portion 51 to be secured and connected to the interconnector and a first non-connecting portion 42 that is a gap without connected to the interconnector. First connecting portion 51 and first non-connecting portion 42 are alternately arranged.

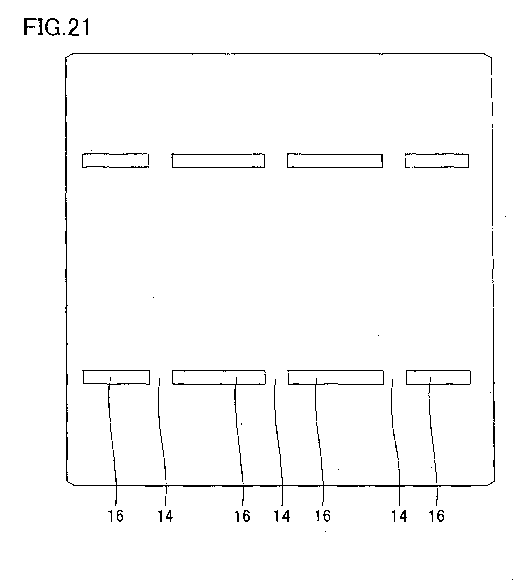

Fig. 21 shows a schematic plan view of an example of electrodes formed at the rear surface of the solar cell used for the interconnector-equipped solar cell of the present invention. As shown in Fig. 21, at the second main surface of p-type silicon substrate 10 that is the rear surface of the solar cell, silver electrode 16 that is a second connecting portion to be connected to the interconnector and a second non-connecting portion without connected to the interconnector are alternately arranged. The second non-connecting portion is formed with an aluminum electrode 14 between adjacent silver electrodes 16. The rear surface that is the second main surface of the semiconductor substrate is a main surface opposite to the light-receiving surface which is the first main surface of the semiconductor substrate.

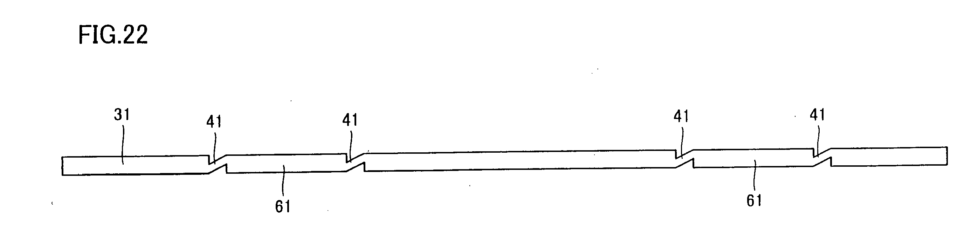

Fig. 22 shows a schematic plan view of a preferred example of the interconnector used for the interconnector-equipped solar cell of the present invention. Interconnector 31 includes a plurality of small cross-sectional area portions 41 where the cross-sectional area of a cross section perpendicular to the longitudinal direction of interconnector 31 is locally smaller, and a non-small cross-sectional area portion 61 located between small cross-sectional area portions 41. Non-small cross-sectional area portion 61 of interconnector 31 is larger than small cross-sectional area portion 41 in cross-sectional area of a cross section perpendicular to the longitudinal direction of interconnector 31.

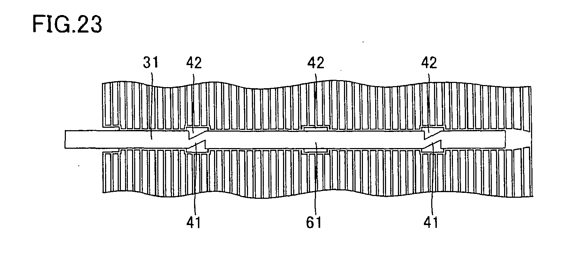

Fig. 23 shows a schematic enlarged plan view of the light-receiving surface of a preferred example of the interconnector-equipped solar cell of the present invention. The interconnector-equipped solar cell shown in Fig. 23 is formed by connecting interconnector 31 shown in Fig. 22 to the first connecting portion of the light-receiving surface of the solar cell having the light-receiving surface shown in Fig. 20 and the rear surface shown in Fig. 21. In the interconnector-equipped solar cell of the present invention, two small cross-sectional area portions 41 of interconnector 31 are disposed at portions corresponding to first non-connecting portions 41 located on the opposing ends among first non-connecting portions 42 disposed at the light-receiving surface of the solar cell. Non-small cross-sectional area portion 61 of interconnector 31 is disposed at a portion corresponding to one first non-connecting portion 42 located between respective first non-connecting portions 42 at the opposing ends.

As shown in Fig. 23, in the interconnector-equipped solar cell of the present invention, first non-connecting portion 42 is disposed at the portion corresponding to small cross-sectional area portion 41, and additionally first non-connecting portion 42 is also disposed at the portion corresponding to non-small cross-sectional area portion 61 between small cross-sectional area portions 41. Thus, for the interconnector-equipped solar cell of the present invention, in a cooling process after a heating process of securing and connecting first connecting portion 51 of the solar cell and interconnector 31 with a solder for example, respective internal stresses that may be generated at p-type silicon substrate 10 and interconnector 31 respectively can be alleviated not only at small cross-sectional area portion 41 of interconnector 31 but also at non-small cross-sectional area portion 61 between small cross-sectional area portions 41. Therefore, as compared with the interconnector-equipped solar cell using the interconnector of Patent Document 1, warp of the solar cell caused by connection of the interconnector can further be reduced.

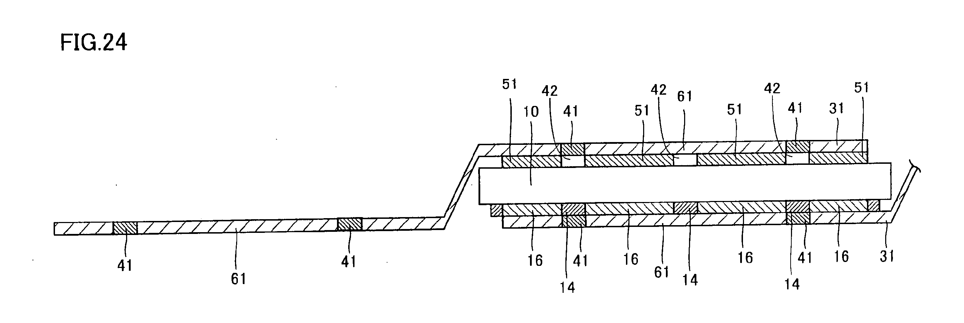

Fig. 24 shows a schematic cross section of the interconnector-equipped solar cell of the present invention shown in Fig. 23. In the interconnector-equipped solar cell of the present invention, silver electrode 16 that is the second connecting portion and first connecting portion 51 are disposed at respective positions symmetrical to each other with respect to p-type silicon substrate 10 that is the semiconductor substrate. One of the reasons why the solar cell is warped is the fact that the light-receiving surface and the rear surface of the solar cell are different in internal stress generated at the solar cell due to a difference in thermal expansion coefficient between the solar cell and the interconnector. The above-described structure, however, can allow respective internal stresses at the light-receiving surface and the rear surface of the solar cell to be equal to each other that are generated at the solar cell due to a difference in thermal expansion coefficient between the solar cell and the interconnector.

Accordingly, for this interconnector-equipped solar cell, in the case where a difference in thermal expansion coefficient between the solar cell and the interconnector causes an internal stress of the solar cell, the effect is obtained of alleviating the internal stress by free extension of the small cross-sectional area portion that is not connected to the solar cell as disclosed in Patent Document 1, the effect can also be obtained of alleviating the stress by free deformation of the non-small cross-sectional area portion without connected to the solar cell. Furthermore, the effect can be obtained that respective internal stresses of the light-receiving surface and the rear surface of the solar cell are substantially equal to each other because the first connecting portion of the light-receiving surface and the second connecting portion of the rear surface of the solar cell are disposed at respective positions symmetrical to each other with respect to the semiconductor substrate. With these effects, it can be expected that the reduction of the warp of the solar cell caused by connection of the interconnector is further improved.

### Sixth Embodiment

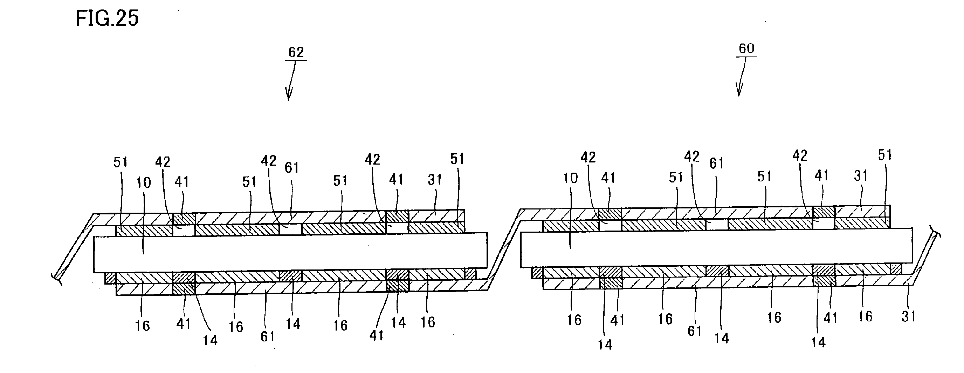

Fig. 25 shows a schematic cross section of a preferred example of the solar cell string of the present invention. The solar cell string is formed by connecting a plurality of interconnector-equipped solar cells of the invention structured as shown in Figs. 23 and 24. Namely, in the interconnector-equipped solar cells of the present invention adjacent to each other, the other end of interconnector 31 having one end connected to the light-receiving surface of a first interconnector-equipped solar cell 60 is connected to silver electrode 16 which is the second connecting portion at the rear surface of a second interconnector-equipped solar cell 62, and accordingly the solar cell string of the present invention is structured.

Two small cross-sectional area portions 41 of interconnector 31 are disposed at portions corresponding to first non-connecting portions 42 located at the opposing ends among first non-connecting portions 42 disposed at the light-receiving surface of first interconnector-equipped solar cell 60. Non-small cross-sectional area portion 61 of interconnector 31 1 is disposed at the portion corresponding to one first non-connecting portion 42 located between first non-connecting portions 42 located at the opposing ends. Two small cross-sectional area portions 41 of interconnector 31 are disposed at respective portions corresponding to second non-connecting portions on the opposing ends among second non-connecting portions disposed at the rear surface of second interconnector-equipped solar cell 62. Non-small cross-sectional area portion 61 of interconnector 31 is disposed at the portion corresponding to one second non-connecting portion located between second non-connecting portions on the opposing ends.

Further, preferably, in each of first interconnector-equipped solar cell 60 and second interconnector-equipped solar cell 62, silver electrode 16 which is the second connecting portion and first connecting portion 51 are disposed at respective positions symmetrical to each other with respect to p-type silicon substrate 10 which is the semiconductor substrate, in terms of reduction of warp of the solar cells constituting the solar cell string.

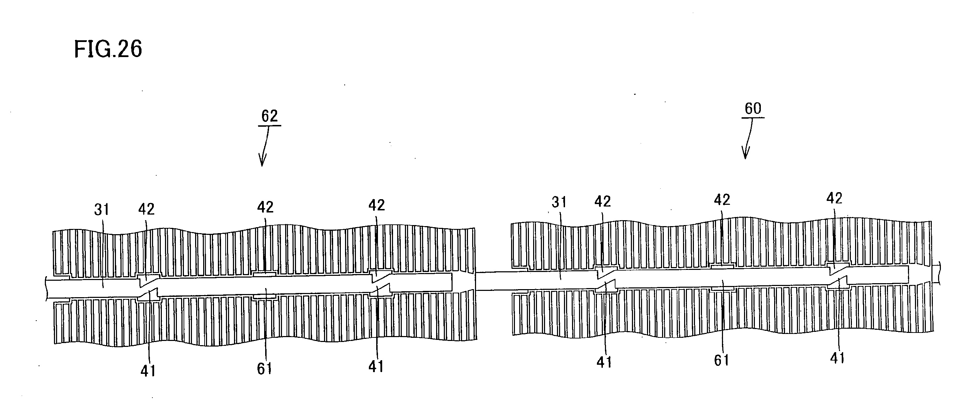

Fig. 26 shows a schematic plan view of the light-receiving surface of the solar cell string of the present invention shown in Fig. 25. In the solar cell string of the present invention, small cross-sectional area portions 41 of interconnector 31 are disposed at respective portions corresponding to first non-connecting portions 42 on the opposing ends among first non-connecting portions 42 disposed at the light-receiving surface of first interconnector-equipped solar cell 60 and portions corresponding to first non-connecting portions 42 on the opposing ends among first non-connecting portions 42 disposed at the light-receiving surface of second interconnector-equipped solar cell 62.

Non-small cross-sectional area portions 61 of interconnector 31 are disposed at the portion corresponding to one first non-connecting portion 42 between the first non-connecting portions 42 on the opposing ends disposed at the light-receiving surface of first interconnector-equipped solar cell 60, and disposed at the portion corresponding to one first non-connecting portion 42 between first non-connecting portions 42 on the opposing ends disposed at the light-receiving surface of second interconnector-equipped solar cell 62.

Small cross-sectional area portions 41 of interconnector 31 are disposed at respective portions corresponding to the second non-connecting portions on the opposing ends among second non-connecting portions disposed at the rear surface of first interconnector-equipped solar cell 60 and corresponding to the second non-connecting portions on the opposing ends among second non-connecting portions disposed at the rear surface of second interconnector equipped solar cell 62.

Therefore, regarding the solar cell string of the present invention, in the case where an internal stress is generated in the solar cell due to a difference in thermal expansion coefficient between the solar cell and the interconnector, the effect of alleviation of the stress can be obtained by free extension of small cross-sectional area portion 41 which is not connected to the solar cell, as disclosed in Patent Document 1, and further the effect of alleviation can be obtained by free deformation of non-small cross-sectional area portion 61 which is not connected to the solar cell, and the effects are achieved for the light-receiving surfaces and the rear surfaces respectively of both of interconnector-equipped solar cell 60 and interconnector-equipped solar cell 62. Moreover, since the first connecting portion of the light-receiving surface of the solar cell and the second connecting portion of the rear surface thereof are positioned symmetrically to each other with respect to the semiconductor substrate, the additional effect that respective internal stresses of the light-receiving surface and the rear surface of the solar cell are substantially equal to each other can be obtained. Therefore, it can be expected that reduction of the warp of the solar cell due to connection of the interconnector is further improved.

Such a solar cell string of the present invention can be sealed with a sealing material such as EVA by a conventionally known method to obtain a solar cell module of the present invention.

### Seventh Embodiment

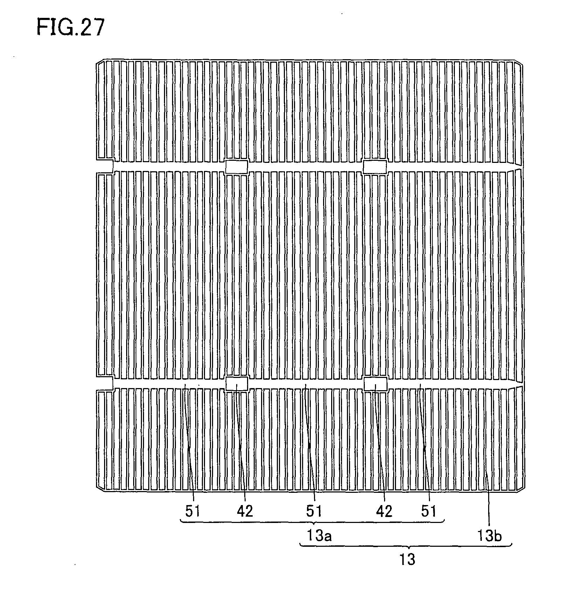

Fig. 27 shows a schematic plan view of an example of electrodes formed at the light-receiving surface of a solar cell of the present invention. At the first main surface of the p-type silicon substrate that is the light-receiving surface of the solar cell of the present invention, a linear first bus bar electrode 13a of a relatively large width extending laterally on this drawing and a plurality of linear finger electrodes 13b of a smaller width extending longitudinally on the drawing from first bus bar electrode 13a are provided. First bus bar electrode 13a includes a linear first connecting portion 51 to be secured and connected to an interconnector and a first non-connecting portion 42 which is a gap without connected to the interconnector, and first connecting portion 51 and first non-connecting portion 42 are arranged alternately.

First bus bar electrode 13a has a hollow pattern portion where first non-connecting portion 42 which is a gap between adjacent first connecting portions 51 has its periphery surrounded by first bus bar electrode 13a. While first bus bar electrode 13a in first connecting portion 51 continues with a constant width, the width of first non-connecting portion 42 is larger than the width of first bus bar electrode 13a in first connecting portion 51. Therefore, the width of first bus bar electrode 13a in the hollow pattern portion is smaller than the width of first bus bar electrode 13 a in first connecting portion 51. First connecting portion 51 adjacent to the left end on the drawing of the first main surface of the p-type silicon substrate is disposed apart from the left end on the drawing of the first main surface of p-type silicon substrate.

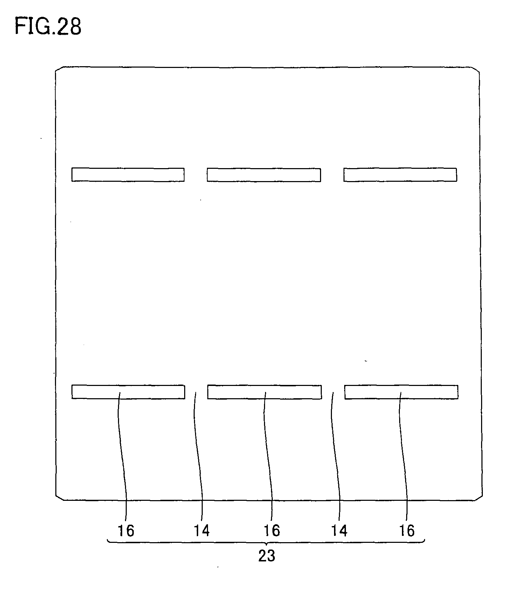

Fig. 28 shows a schematic plan view of an example of electrodes formed at the rear surface of the solar cell shown in Fig. 27. At the second main surface of the p-type silicon substrate, which is the rear surface of the solar cell of the present invention, silver electrode 16 which is the second connecting portion to be connected to the interconnector and aluminum electrode 14 which is the second non-connecting portion without connected to the interconnector are alternately disposed laterally on the drawing. A second bus bar electrode 23 is formed by silver electrode 16 which is the second connecting portion and aluminum electrode 14 which is the second non-connecting portion that are alternately arranged. Second non-connecting portion 42 is formed by aluminum electrode 14 located between silver electrodes 16 adjacent to each other.

Silver electrode 16 which is the second connecting portion on the second main surface of the p-type silicon substrate is disposed at the position substantially symmetrical to the position of first connecting portion 51 on the first main surface of the p-type silicon substrate, with respect to the p-type silicon substrate. Relative to the length of aluminum electrode 14 which is the second non-connecting portion located between silver electrodes 16 adjacent to each other in the longitudinal direction of silver electrode 16 on the second main surface of the p-type silicon substrate (namely the shortest distance between silver electrodes 16 adjacent to each other in the longitudinal direction of silver electrode 16), the length of first non-connecting portion 42 is longer that is located between first connecting portions 51 adjacent to each other in the longitudinal direction of the first connecting portion 51 on the first main surface of the p-type silicon substrate (namely the shortest distance between first connecting portions 51 adjacent to each other in the longitudinal direction of first connecting portion 51).

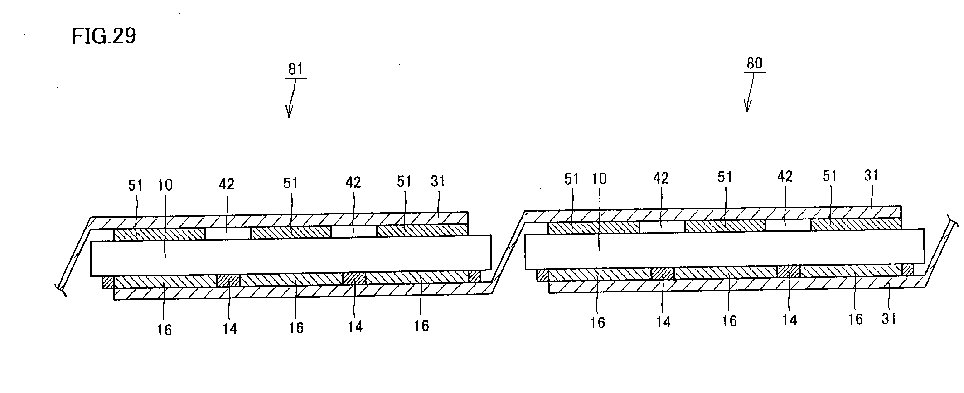

Fig. 29 shows a schematic cross section of an example of the solar cell string of the present invention, in which the solar cells having the electrodes on the light-receiving surface side shown in Fig. 27 as well as the electrodes on the rear surface side shown in Fig. 28 are connected in series. In a first solar cell 80 and a second solar cell 81 adjacent to each other, first connecting portion 51 of first solar cell 80 and silver electrode 16 which is the second connecting portion of second solar cell 81 are secured and connected to interconnector 31 formed of one electrically conductive member with a solder for example. First non-connecting portion 42 and aluminum electrode 14 which is a second non-connecting portion 14 of the solar cell are not secured to interconnector 31 and not connected to interconnector 31. At an end of the solar cell (here, an end of first solar cell 80 and an end of second solar cell 81), interconnector 31 is bent. In Fig. 29, the n+ layer and p+ layer are not shown.

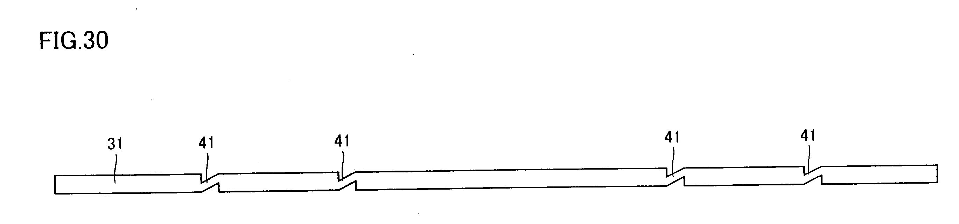

Fig. 30 shows a schematic plan view of an example of the interconnector used for the present invention. Interconnector 31 has a small cross-sectional area portion 41 where the cross-sectional area of a cross section perpendicular to the longitudinal direction of interconnector 31 is locally reduced. Preferably, interconnector 31 is connected such that small cross-sectional area portion 41 is disposed in at least one of those portions corresponding to first non-connecting portion 42 and aluminum electrode 14 which is a second non-connecting portion as shown in Fig. 29, or disposed in all of the portions. In this case, since small cross-sectional area portion 41 that has a relatively small cross-sectional area is not secured to the solar cell and freely extends so that the stress can be alleviated. Therefore, there is a tendency that any warp of the solar cells constituting the solar cell string can further be reduced, as compared with the case where an interconnector without small cross-sectional area portion 41 is used. Although not shown here, in the solar cell string of the invention shown in Fig. 29, respective small cross-sectional area portions 41 of interconnector 31 are disposed at all portions corresponding to hollow pattern portions of the light-receiving surface of the solar cell and all portions corresponding to aluminum electrodes 14 that are second non-connecting portions.

For the solar cell string of the present invention structured in the above-described manner, the length of connection between the interconnector and the first connecting portion of the solar cell can be reduced as compared with the conventional solar cell string. In the case where the length of connection between the interconnector and the first connecting portion of the solar cell is thus reduced, the stress caused by a difference in thermal expansion coefficient between the interconnector and the p-type silicon substrate which is a component of the solar cell can be reduced. Accordingly, it can be expected that, for the solar cells constituting the solar cell string, reduction of warp of the solar cells caused by connection of the interconnector is further improved.

Further, for the solar cell string shown in Fig. 29, splits and cracks generated in the solar cell when the solar cell string of the present invention is fabricated can be remarkably reduced. It is considered that this effect is obtained by the fact that, relative to the length of aluminum electrode 14 that is a second non-connecting portion on the rear surface of the solar cell, the length of first non-connecting portion 42 on the light-receiving surface of the solar cell is longer.

Such a solar cell string of the present invention can be sealed with a sealing material such as EVA by a conventionally known method to obtain a solar cell module of the present invention.

### Eighth Embodiment

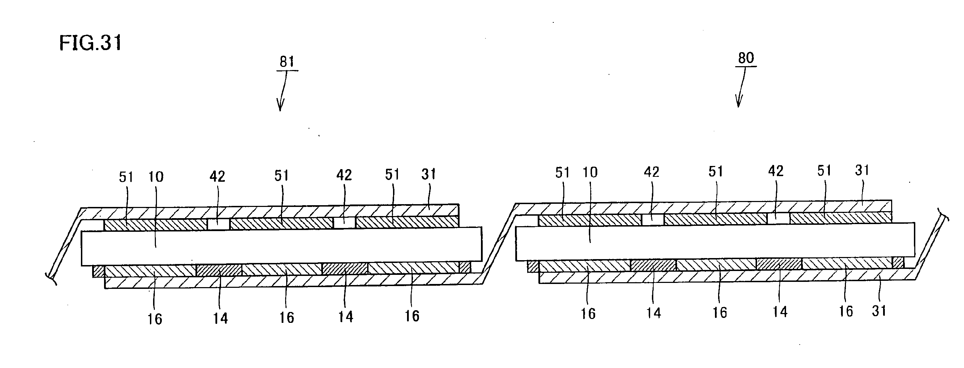

Fig. 31 shows a schematic cross section of another example of the solar cell string of the present invention. A feature of the solar cell string of the invention shown in Fig. 31 is that, relative to the length of aluminum electrode 14 that is a second non-connecting portion on the rear surface of the solar cell, the length of first non-connecting portion 42 on the light-receiving surface of the solar cell is shorter. The description of other features are similar to that of the solar cell string in the seventh embodiment.

With the above-described structure as well, it can be expected that reduction of the warp of the solar cell caused by connection of the interconnector is further improved since the length of connection between the interconnector and the first connecting portion of the solar cell is reduced, like the solar cell string in the seventh embodiment.

Further, for the solar cell string shown in Fig. 31 as well, splits and cracks generated in the solar cell when the solar cell string of the present invention is fabricated can remarkably be reduced. It is considered that this effect is obtained by the fact that, relative to the length of first non-connecting portion 42 on the light-receiving surface of the solar cell, the length of aluminum electrode 14 which is a second non-connecting portion on the rear surface of the solar cell is longer.

Such a solar cell string of the present invention can be sealed with a sealing material such as EVA by a conventionally known method to obtain a solar cell module of the present invention.

Although other descriptions of the above first to eighth embodiments are similar to the description in the BACKGROUND ART section above, they are not restricted to this description. For example, according to the present invention, any semiconductor substrate other than the p-type silicon substrate may be used, and the electrical conductivities, namely p-type and n-type in the above description of the BACKGROUND ART section may be replaced with each other. Further, according to the present invention, the first connecting portion and the second connecting portion may not necessarily be the silver electrode. Furthermore, according to the present invention, the first non-connecting portion may not necessarily be the gap, and the second non-connecting portion may not necessarily be the aluminum electrode.

### Examples

### Example 1

A solar cell having the electrodes of the light-receiving surface shown in Fig. 1 (a) and the electrodes of the rear surface shown in Fig. 2 was fabricated. The solar cell had a width of 156.5 mm, a length of 156.5 mm and a thickness of the whole solar cell of 120 µm.

First connecting portion 51 of the light-receiving surface shown in Fig. 1 (a) had a width of 3 mm and a length of approximately 40 mm, and first non-connecting portion 42 that was a gap of a hollow pattern portion had a width of 4.4 mm and a length of 7 mm. Bus bar electrode 13a surrounding the periphery of first non-connecting portion 42 had a width of 600 µm. The distance between two bus bar electrodes 13a was 74 mm. Here, bus bar electrode 13a and finger electrode 13b was made of silver.

The second connecting portion of silver electrode 16 of the rear surface shown in Fig. 2 had a width of 4 mm and a length of approximately 40 mm, and the second non-connecting portion of aluminum electrode 14 located between second connecting portions had a width of 4 mm and a length of 7 mm. First connecting portion 51 shown in Fig. 1 (a) and the second connecting portion shown in Fig. 2 were formed at respective positions symmetrical to each other with respect to p-type silicon substrate 10. First non-connecting portion 42 shown in Fig. 1 (a) and aluminum electrode 14 which was the second non-connecting portion shown in Fig. 2 were formed at respective positions symmetrical to each other with respect to the p-type silicon substrate.

Two solar cells with the above-described structure were prepared. First connecting portion 51 of the light-receiving surface of one solar cell and the second connecting portion of the rear surface of the other solar cell were connected with respective solders to interconnector 31 shown in Fig. 8, thereby forming a solar cell string. Interconnector 31 was bent at respective ends of the solar cells.

Interconnector 31 shown in Fig. 8 was formed such that the interconnector has respective small cross-sectional area portions 41 made by a narrowed portion as shown in Fig. 8 that are located at all portions corresponding to first non-connecting portions 42 shown in Fig. 1 (a) and all portions corresponding to aluminum electrodes 14 that were second connecting portions shown in Fig. 2, in the state where interconnector 31 is connected. Interconnector 31 shown in Fig. 8 was made of copper and had a thickness of 200 µm. Interconnector 31 shown in Fig. 8 had a width of 2.5 mm, and the width of the narrowest portion of small cross-sectional area portion 41 was 1 mm.

A warp of a solar cell after the solar cell string was formed was measured. The results are shown in Table 1.

### Comparative Example 1

A solar cell having the electrodes of the light-receiving surface shown in Fig. 37 and the electrodes of the rear surface shown in Fig. 38 was fabricated. The solar cell had a width of 156.5 mm, a length of 156.5 mm and a thickness of the whole solar cell of 120 µm.

Bus bar electrode 13a of the light-receiving surface shown in Fig. 37 had a width of 2 mm and a length of 150 mm. The distance between two bus bar electrodes 13a was 75 mm.

Silver electrode 16 of the rear surface shown in Fig. 38 had a width of 4 mm and a length of 10 mm. The distance between silver electrodes 16 adjacent to each other in the longitudinal direction of silver electrode 36 was 15 mm, and the distance between silver electrodes 16 adjacent to each other in the direction orthogonal to the longitudinal direction of silver electrode 16 was 73 mm.

Two solar cells having the above-described structure were prepared, and silver electrode 13 of the light-receiving surface of one solar cell and silver electrode 16 of the rear surface of the other solar cell were connected with respective solders to interconnector 31 shown in Fig. 8 to form a solar cell string. In Comparative Example 1, the interconnector of the same shape, the same dimensions and the same material as those of the interconnector used in Example 1 was used. Interconnector 31 was bent at an end of the solar cell.

With the same method and under the same conditions as those of Example 1, a warp of the solar cell after the solar cell string was formed was measured. The results are shown in Table 1.

### Comparative Example 2

A solar cell string was formed similarly to Comparative Example 1 except that a band-shaped interconnector without small cross-sectional area portion was used.

With the same method and under the same conditions as those of Example 1, a warp of the solar cell after the solar cell string was formed was measured. The results are shown in Table 1.

**Table 1**

| | electrode pattern of light-receiving surface | electrode pattern of rear surface | interconnector | thickness of solar cell | warp of solar cell |
|---|---|---|---|---|---|
| Example 1 | Fig.1(a) | Fig. 2 | with narrowed portion (Fig. 8) | 120 µm | 9.8 mm |
| Comparative Example 1 | Fig. 37 | Fig. 38 | with narrowed portion (Fig. 8) | 120 µm | 12.8 mm |
| Comparative Example 2 | Fig. 37 | Fig. 38 | band-shaped | 120 µm | 13.1 mm |

As shown in Table 1, it was confirmed that the solar cell string of Example 1 had a reduced warp of the solar cells constituting the solar cell string, as compared with respective solar cell strings of Comparative Examples 1 and 2.

It is considered that a first reason for the above described results is that the first connecting portion and the first non-connecting portion of the light-receiving surface of the solar cell string of Example 1 are alternately arranged so that the length of connection between the interconnector and the solar cell is reduced. It is also considered that a second reason therefor is that the first connecting portion and the second connecting portion, and the first non-connecting portion and the second non-connecting portion of the solar cell string of Example 1 are formed at respective positions symmetrical to each other with respect to the semiconductor substrate, so that equal forces are exerted on the solar cell respectively from the light-receiving surface and the rear surface of the solar cell. It is further considered that a third reason therefor is that, when resilience of the solar cell is generated when the solar cell string is formed, the small cross-sectional area portion having a relatively lower strength than other portions of the interconnector extends to alleviate the internal stress.

### Example 2

A solar cell string was formed similarly to Example 1 except that interconnector 31 having the notch shown in Fig. 7 was used instead of interconnector 31 having the narrowed portion shown in Fig. 8. The solar cell strings thus formed were connected in series to form a solar cell string made up of 48 solar cells.

The number of defective connections and the rate of occurrence of defective connections of the interconnectors of the solar cell string were examined. The results are shown in Table 2.

### Comparative Example 3

A solar cell string made up of 48 solar cells was formed similarly to Example 2 except that a solar cell of a similar structure to Comparative Example 1 was used.

The number of defective connections and the rate of occurrence of defective connections of the interconnector of the solar cell string were examined. The results are shown in Table 2.

### Comparative Example 4

A solar cell string made up of 96 solar cells was formed similarly to Comparative Example 3 except that an interconnector structured similarly to Comparative Example 1 was used.

The number of defective connections and the rate of occurrence of defective connections of the interconnector of the solar cell string were examined. The results are shown in Table 2.

**Table 2**

| | electrode pattern of light-receiving surface | electrode pattern of rear surface | interconnector | thickness of solar cell | number of defective connections | rate of occurrence of defective connections |
|---|---|---|---|---|---|---|
| Example 2 | Fig. 1 (a) | Fig. 2. | with notch (Fig. 7) | 120 µm | 0 defects/48 products | 0% |
| Comparative Example 3 | Fig. 37 | Fig. 38 | with notch (Fig. 7) | 120 µm | 6 defects/48 products | 12.5% |
| Comparative Example 4 | Fig. 37 | Fig. 38 | with narrowed portion (Fig. 8) | 120 µm | 24 defects/96 products | 25.0% |

As shown in Table 2, it was confirmed that the solar cell string of Example 2 had a reduced number of defective connections and a reduced rate of occurrence of defective connections, as compared with respective solar cell strings of Comparative Examples 3 and 4.

Regarding the solar cell string of Example 2, it is considered that a reason for the above is that the warp of solar cells constituting the solar cell string can be reduced as compared with respective solar cell strings of Comparative Example 3 and Comparative Example 4.

### Example 3

A solar cell having the electrodes of the light-receiving surface shown in Fig. 27 and the electrodes of the rear surface shown in Fig. 28 was fabricated. The solar cell had a width of 156.5 mm, a length of 156.5 mm and a thickness of the whole solar cell of 120 µm.

First connecting portion 51 of the light-receiving surface shown in Fig. 27 had a width of 3 mm and a length of approximately 40 mm. First non-connecting portion 42 that was a gap of a hollow pattern portion had a width of 4.4 mm and a length of 9 mm. The width of first bus bar electrode 13a surrounding the periphery of first non-connecting portion 42 was 600 µm. The distance between two first bus bar electrodes 13a was 74 mm. First bus bar electrode 13a and finger electrode 13b were made of silver.

A second connecting portion of silver electrode 16 of the rear surface shown in Fig. 28 had a width of 4 mm and a length of approximately 40 mm, and a second non-connecting portion of aluminum electrode 14 located between second connecting portions had a width of 4 mm and a length of 7 mm. First connecting portion 51 shown in Fig. 27 and the aluminum electrode of the second connecting portion shown in Fig. 28 were formed at respective positions symmetrical to each other with respect to the p-type silicon substrate. The length of first non-connecting portion 42 is formed longer than the length of the second non-connecting portion.

Two solar cells of the above-described structure were prepared, and first connecting portion 51 of the light-receiving surface of first solar cell 80 and the second connecting portion of the rear surface of second solar cell 81 were connected with respective solders with interconnector 31 shown in Fig. 29 to form a solar cell string of Example 1. Interconnector 31 was bent at an end of first solar cell 80 and an end of second solar cell 81. Interconnector 31 was made of copper and had a thickness of 200 µm. Interconnector 31 had a width of 2.5 mm.

The rate of occurrence of splits and cracks occurring in the solar cells when the interconnector was connected for fabricating the solar cell string of Example 3 was counted.

As a result, the rate of occurrence of splits and cracks caused in the solar cell when the interconnector was connected for fabricating the solar cell string of Example 3 was remarkably lower than that in the case where the solar cell string of Example 4 described hereinlater was fabricated.

### Example 4

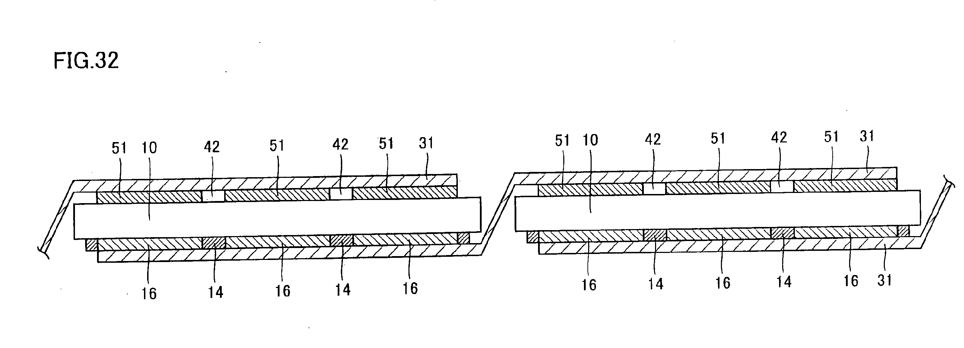

A solar cell string was fabricated similarly to Example 3 except that the solar cell string having the structure whose schematic cross section is shown in Fig. 32 was fabricated. The rate of occurrence of splits and cracks generated in the solar cells when the interconnector was connected for fabricating the solar cell string was counted.

Here, regarding the solar cell string of Example 4, as shown in the schematic enlarged cross section of Fig. 33, the length of first non-connecting portion 42 and the length of aluminum electrode 14 serving as a second non-connecting portion were equal to each other and were 7 mm. In Example 4, interconnector 31 of the same shape as Example 3 was used. As Example 3, small cross-sectional area portions 41 of interconnector 31 were disposed at all portions corresponding to first non-connecting portion 42 that was a gap of a hollow pattern portion of the light-receiving surface of the solar cell and all portions corresponding to aluminum electrode 14 that was a second non-connecting portion.

It should be construed that embodiments disclosed above are by way of illustration in all respects, not by way of limitation. It is intended that the scope of the present invention is defined by claims, not by the embodiments and examples above, and includes all modifications and variations equivalent in meaning and scope to the claims.

### INDUSTRIAL APPLICABILITY

According to the present invention, the stress due to a difference in thermal expansion coefficient between the interconnector and the solar cell is alleviated, and consequently the warp occurring in the solar cell which is a component of the solar cell string is reduced and the reliability of the connection between the interconnector and the solar cell is improved.

Further, according to the present invention, the warp occurring in the solar cell which is a component of the solar cell string is reduced, and thus a transport error in the transport system of the fabrication line of the solar cell module as well as splits of the solar cell are reduced.

Furthermore, according to the present invention, splits of the solar cell in the process of sealing for fabricating a solar cell module can also be reduced, and thus the yield and productivity of the solar cell module are improved.

## Claims

1. A solar cell comprising a semiconductor substrate (10) including a first main surface, a bus bar electrode (13a) and a plurality of linear finger electrodes (13b) extending from said bus bar electrode (13a) being provided on the first main surface,
said bus bar electrode (13a) including a first connecting portion (51) to be connected to an interconnector (31) and a first non-connecting portion (42) without connected to the interconnector (3 1), and
said first connecting portion (51) and said first non-connecting portion (42) being arranged alternately.

2. The solar cell according to claim 1, wherein
on a second main surface opposite to said first main surface of said semiconductor substrate (10), a second connecting portion (16) to be connected to the interconnector (31) and a second non-connecting portion (14) without connected to the interconnector are alternately arranged.

3. The solar cell according to claim 2, wherein
said first connecting portion (51) and said second connecting portion (16) are disposed at respective positions symmetrical to each other with respect to said semiconductor substrate (10).

4. The solar cell according to claim 2, wherein
said first non-connecting portion (42) located between said first connecting portions (51) adjacent to each other has a length longer than the length of said second non-connecting portion (14) located between said second connecting portions (16) adjacent to each other, or said second non-connecting portion (14) located between said second connecting portions (16) adjacent to each other has a length longer than said first non-connecting portion (42) located between said first connecting portions (51) adjacent to each other.

5. The solar cell according to claim 1, wherein
said first connecting portion (51) is linearly formed.

6. The solar cell according to claim 1, wherein
said bus bar electrode (13a) has a hollow pattern portion including said first non-connecting portion (42).

7. The solar cell according to claim 6, wherein
said bus bar electrode (13a) in said hollow pattern portion has a width smaller than the width of said bus bar electrode (13a) in said first connecting portion (51).

8. The solar cell according to claim 6, wherein
said bus bar electrode (13a) includes a plurality of said hollow pattern portions, and said hollow pattern portions adjacent to each other are at regular intervals.

9. The solar cell according to claim 6, wherein
at least one of a distance between an end of said first main surface and said hollow pattern portion adjacent to said end of said first main surface and a distance between another end of said first main surface and said hollow pattern portion adjacent to said another end is smaller than a distance between said hollow pattern portions adjacent to each other.

10. The solar cell according to claim 6, wherein
at least one of said first connecting portions (51) adjacent respectively to ends of said first main surface is disposed apart from the end of said first main surface.

11. An interconnector-equipped solar cell including an interconnector (31) connected to said first connecting portion (51) of the solar cell as recited in claim 1.

12. The interconnector-equipped solar cell according to claim 11, wherein
said interconnector (31) includes a small cross-sectional area portion (41) where a cross-sectional area of a cross section perpendicular to a longitudinal direction of the interconnector is locally small, and
said small cross-sectional area portion (41) is disposed at said first non-connecting portion (42).

13. The interconnector-equipped solar cell according to claim 12, wherein
said interconnector (31) includes a plurality of said small cross-sectional area portions (41) and a non-small cross-sectional area portion (61) located between said small cross-sectional area portions (41), and said non-small cross-sectional area portion (61) is disposed at said first non-connecting portion (42).

14. The interconnector-equipped solar cell according to claim 11, wherein
on a second main surface opposite to said first main surface of said semiconductor substrate (10), a second connecting portion (16) to be connected to the interconnector (31) and a second non-connecting portion (14) without connected to the interconnector (31) are arranged alternately.

15. A solar cell string comprising a plurality of solar cells connected to each other, said solar cell including: a bus bar electrode (13a) including a first connecting portion (51) to be connected to an interconnector (31) and a first non-connecting portion (42) without connected to the interconnector (31), said first connecting portion and said first non-connecting portion being arranged alternately on a first main surface of a semiconductor substrate (10); a plurality of linear finger electrodes (13b) extending from said bus bar electrode (13a); a second connecting portion (16) to be connected to the interconnector (31); and a second non-connecting portion (14) without connected to the interconnector (31), said second connecting portion and said second non-connecting portion being arranged alternately on a second main surface opposite to said first main surface of said semiconductor substrate (10), and
said first connecting portion (51) of a first solar cell (80) and said second connecting portion (16) of a second solar cell (81) adjacent to said first solar cell being connected to the interconnector (31).

16. The solar cell string according to claim 15, wherein
said interconnector (31) is bent at an end of said first solar cell (80) and an end of said second solar cell (81).

17. The solar cell string according to claim 15, wherein
said interconnector (31) includes a small cross-sectional area portion (41) where a cross-sectional area of a cross section perpendicular to a longitudinal direction of the interconnector is locally small, and
said small cross-sectional area portion (41) is disposed in at least one of a portion corresponding to said first non-connecting portion (42) of said first solar cell (80) and a portion corresponding to said second non-connecting portion (14) of said second solar cell (81).

18. The solar cell string according to claim 15, wherein
said interconnector (31) includes a small cross-sectional area portion (41) where a cross-sectional area of a cross section perpendicular to a longitudinal direction of the interconnector is locally small, and
said small cross-sectional area portion (41) is disposed in all of a portion corresponding to said first non-connecting portion (42) of said first solar cell (80) and a portion corresponding to said second non-connecting portion (14) of said second solar cell (81).

19. A solar cell module comprising the solar cell string as recited in claim 15 sealed with a sealing material.

20. A solar cell string comprising a plurality of solar cells connected to each other, said solar cell including: a bus bar electrode (13a) including a first connecting portion (51) to be connected to an interconnector (31) and a hollow pattern portion having a first non-connecting portion (42) without connected to the interconnector (31), said first connecting portion and said hollow pattern portion being arranged alternately on a first main surface of a semiconductor substrate (10); a plurality of linear finger electrodes (13b) extending from said bus bar electrode (13a); a second connecting portion (16) to be connected to the interconnector (31); and a second non-connecting portion (14) without connected to the interconnector (31), said second connecting portion and said second non-connecting portion being arranged alternately on a second main surface opposite to said first main surface of said semiconductor substrate (10), and
said first connecting portion (51) of a first solar cell (80) and said second connecting portion (16) of a second solar cell (81) adjacent to said first solar cell being connected to the interconnector (31).

21. The solar cell string according to claim 20, wherein
said interconnector (31) includes a small cross-sectional area portion (41) where a cross-sectional area of a cross section perpendicular to a longitudinal direction of the interconnector is locally small, and
said small cross-sectional area portion (41) is disposed in at least one of a portion corresponding to said hollow pattern portion of said first solar cell (80) and a portion corresponding to said second non-connecting portion (14) of said second solar cell (81).

22. The solar cell string according to claim 20, wherein
said interconnector (31) includes a small cross-sectional area portion (41) where a cross-sectional area of a cross section perpendicular to a longitudinal direction of the interconnector is locally small, and
said small cross-sectional area portion (41) is disposed in all of a portion corresponding to said hollow pattern portion of said first solar cell (80) and a portion corresponding to said second non-connecting portion (14) of said second solar cell (81).

23. A solar cell module comprising the solar cell string as recited in claim 20 sealed with a sealing material.
